(19) Europäisches Patentamt
European Patent Office
Office européen des brevets

(11) EP 4 289 519 A1

(12) EUROPEAN PATENT APPLICATION

(43) Date of publication:
**13.12.2023 Bulletin 2023/50**

(21) Application number: **22178306.1**

(22) Date of filing: **10.06.2022**

(51) International Patent Classification (IPC):
***B05D 1/00*** *(2006.01)* ***C23C 16/50*** *(2006.01)*
***C23C 16/455*** *(2006.01)*

(52) Cooperative Patent Classification (CPC):
**C23C 16/50; B05D 1/62; C23C 16/45595;**
B05D 2201/00

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **BASF SE**
**67056 Ludwigshafen am Rhein (DE)**

(72) Inventors:
- **HIRTH, Sabine**
**67056 Ludwigshafen am Rhein (DE)**
- **KELLERMEIER, Matthias**
**67056 Ludwigshafen am Rhein (DE)**
- **LANGER, Nicolle**
**67117 Limburgerhof (DE)**
- **FREIRE CORREA, Mateus**
**67117 Limburgerhof (DE)**

(74) Representative: **Altmann Stößel Dick Patentanwälte PartG mbB**
**Isartorplatz 1**
**80331 München (DE)**

# (54) PLASMA-CREATED BARRIERS FOR PACKAGING

(57) In a first aspect, the invention relates to a coated substrate, wherein the coating is obtained or obtainable from depositing on a surface of a substrate by a plasma-assisted deposition method a reaction product of a fluorine-free compound selected from the group consisting of a lactam with 4 to 8 ring atoms, a lactone with 4 to 8 ring atoms, vinylacetate, polyvinylpyrrolidone, C5 to C8 alkyne and mixtures of two or more of these compounds.

A second aspect of the invention is related to a plasma-assisted deposition method for applying a coating based on a reaction product of a fluorine-free compound onto a surface of a substrate.

A third aspect of the invention is related to the use of a coated substrate according to the first aspect or of a coated substrate obtained or obtainable from the plasma-assisted deposition method of the second aspect, for packaging, storing and/or transporting a good selected from the group consisting of food, beverage and chemical wherein the good is preferably a chemical, wherein the chemical is preferably a hazardous substance (transported as dangerous good) or an agrochemical, more preferably an agrochemical.

EP 4 289 519 A1

## Description

In a first aspect, the invention relates to a coated substrate, wherein the coating is obtained or obtainable from depositing on a surface of a substrate by a plasma-assisted deposition method a reaction product of a fluorine-free compound selected from the group consisting of a lactam with 4 to 8 ring atoms, a lactone with 4 to 8 ring atoms, vinylacetate, polyvinylpyrrolidone, C5 to C8 alkyne and mixtures of two or more of these compounds.

A second aspect of the invention is related to a plasma-assisted deposition method for applying a coating based on a reaction product of a fluorine-free compound onto a surface of a substrate.

A third aspect of the invention is related to the use of a coated substrate according to the first aspect or of a coated substrate obtained or obtainable from the plasma-assisted deposition method of the second aspect, for packaging, storing and/or transporting a good selected from the group consisting of food, beverage and chemical wherein the good is preferably a chemical, more preferably an agrochemical.

State-of-the-art vessels for packaging of plant protection products (PPP), so-called agrochemicals, are usually designed in a way that the walls of the vessels do not allow permeation of the agrochemicals, solvents and/or other formulation components during transport, storage and application. This requires commonly used packaging materials such as polyethylene (PE) to be equipped with a barrier technology. Major established industrial processes to achieve this rely on (i) compounding or coextruding PE with less permeable polymers like polyamide (PA) or ethylene-vinylalcohol (EVOH) copolymer, e.g. in the form of thick (multi-$\mu$m) surface or interphase layers, or (ii) coating the interior surfaces of the vessels with thin (typically <1 $\mu$m) layers of (per)fluorinated compounds. The latter (per)fluorinated coatings are classically obtained through gas-phase fluorination or, more recently, can also be achieved by plasma-assisted depositing of gaseous fluorochemicals (so-called "Plasma-enhanced chemical vapor deposition", PECVD). This plasma-based technology - published by Isytech (WO 2007/072120 A1) at low pressure - has proven to yield coatings with superior properties (high barrier effect, little mechanical deformation of containers during coating, easier recyclability) at comparatively low costs (in-line process).

However, both ways, i.e. compounding or coextruding with PA or EVOH as well as coating with a reaction product of (per)fluorinated compounds have severe disadvantages:

> On the one hand, coatings based on (per)fluorinated compounds could fall under future restrictions of the use of perfluorinated alkyl substances (PFAS) in the US and EU27 and thus may need to be replaced by alternative technologies. On the other hand, existing fluorine-free technologies to achieve sufficient barrier properties often require laborious and cost-intensive processes such as coextrusion, wherein the PA or EVOH is coextruded with the substrate material, for example PE. Furthermore, the thickness of the PA or EVOH domains required for sufficient barrier against transmission of solvents and chemicals renders the container a multimaterial, which poses challenges in view of recycling and a circular economy.
>
> Consequently, for the recycling of both types of state-of-the-art barrier technologies, extensive preprocessing steps are required to separate the main container material (e.g. PE) from the barrier components (e.g. large amounts of PA or EVOH, or trace quantities of substances of very high concern (SVHC) such as perfluorinated alkyl species (PFAS)).

Thus, the problem underlying the present invention was the provision of a coating (and a corresponding coating process) for packaging materials employed as containers for chemicals, especially agrochemicals, that meets the following requirements: (i) fluorine-free components to address regulatory concerns; (ii) coating thickness much lower than for established PA or EVOH barrier technologies to facilitate recycling; (iii) barrier performance at least comparable to existing fluorine-containing coatings and PA or EVOH coextrusion multimaterials for functional competitiveness.

<u>1st aspect - the coated substrate</u>

The problem was solved by a coated substrate, wherein the coating is obtained or obtainable from depositing on a surface of a substrate by a plasma-assisted deposition method a reaction product of a fluorine-free compound selected from the group consisting of a lactam with 4 to 8 ring atoms, a lactone with 4 to 8 ring atoms, vinylacetate, polyvinylpyrrolidone, C5 to C8 alkyne and mixtures of two or more of these compounds.

It was surprisingly found that coatings based on the above-identified compounds allow a significant improvement of barrier properties, for example shown by a considerable reduction of the interaction of toluene vapor with the coated container walls, even if the coating is only a few tens of nanometers thick. Toluene is considered a representative solvent for testing barrier properties of a coating against transmission of hazardous compounds as present e.g. in agrochemical formulations. The interaction of toluene vapor with coated and uncoated HDPE substrates was probed by inverse gas chromatography and evaluated in the framework of the Brunauer-Emmett-Teller (BET) theory, which gives the monolayer capacity for toluene binding ($q_{BET}$, expressed as molar amounts of adsorbed toluene molecules per unit of explored

surface area in µmol/$cm^2$) as well as the corresponding dimensionless BET constant ($C_{BET}$) as a measure for the strength of interaction. High barrier against toluene vapor isreflected by low values of $q_{BET}$ and/or $C_{BET}$. It was found that $q_{BET}$ of coatings obtained by plasma-assisted deposition of the fluorine-free compounds according to the invention is in the same range as $q_{BET}$ values of comparative coatings made from fluorine-containing compounds by plasma deposition or gas-phase fluorination as well as HDPE/PA coextrudates. Compared to an uncoated HDPE substrate, $q_{BET}$ is improved by the coating with fluorine-free compounds according to the invention by at least 20 %. $C_{BET}$ of the fluorine-free compounds according to the invention is in the same range as $C_{BET}$ values of a comparative coating made from a fluorine-containing compound as well as HDPE/PA coextrudates.

The coating with reaction products of fluorine-free components allows, due to the use of a plasma-based technique, a much easier application of the coating than established (HD)PE/PA coextrusion technologies; hence it is (much) cheaper to produce these coatings. Use of fluorine-free components avoids the formation and later potential release of (per)fluorinated substances. Due to the low amounts of applied coating material- as indicated above, the layer thicknesses required for sufficient barrier against toluene is only a few tens of nanometers- the coated substrates still qualify as monomaterial and can thus be recycled with much less effort.

In some preferred embodiments of the coated substrate, the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate, polyvinylpyrrolidone, C5 to C8 alkyne and mixtures of two or more of these compounds.

In some preferred embodiments of the coated substrate, the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate, C5 to C8 alkyne and mixtures of two or more of these compounds.

In some preferred embodiments of the coated substrate, the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate and mixtures of two or more of these compounds, preferably selected from the group consisting of a lactone with 4 to 8 ring atoms, vinylacetate and mixtures of two or more of these compounds.

In some preferred embodiments of the coated substrate, the lactam with 4 to 8 ring atoms has

formula (I)

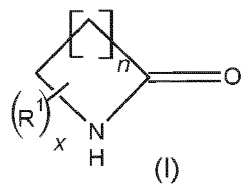

(I)

wherein

- $R^1$ is a vinyl group,
- x is zero or 1, and
- n is an integer in the range of from 2 to 5, preferably in the range of from 2 to 4, more preferably n is 4 and x is zero (epsilon-caprolactam) and/ or n is 2 and x is 1, wherein $R^1$ is a vinyl group substituting the hydrogen atom at the nitrogen of the ring structure (vinylpyrrolidone).

$R^1$ represents a vinyl group and the residue $R^1$, if present, is positioned at the nitrogen atom of the ring structure, where it replaces the hydrogen atom, or at a carbon atom of the ring structure, including any one of the C atoms of the group $-[CH_2]_n-$. Vinylpyrrolidone, which is also a lactam, is N-vinyl-2-pyrrolidone, i.e. the nitrogen atom of the five membered lactam ring (gamma-lactam) bears a vinyl group as substituent instead of a hydrogen atom at this position.

In some preferred embodiments of the coated substrate, the lactone with 4 to 8 ring atoms, preferably 6 to 8 ring atoms, has formula (II)

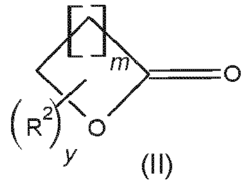

(II)

wherein

$R^2$ is selected from methyl group and vinyl group,
y is zero or 1, and

m is an integer in the range of from 1 to 5, preferably in the range of from 3 to 4, wherein the lactone is more preferably selected from the group consisting of delta-valerolactone, gamma-valerolactone, epsilon-caprolactone, and mixtures of two or more of these lactones, more preferably the lactone comprises at least, more preferably is, gamma-valerolactone. $R^2$ represents a methyl group or a vinyl group and the residue $R^2$, if present, is positioned at a carbon atom of the ring structure, including any one of the C atoms of the group $-[CH_2]_n-$. For example, delta-valerolactone is a six-membered ring with 5 carbon atoms (y = 0), while gamma-valerolactone is a five-membered ring with four carbon atoms and a methyl group as $R^2$ positioned at the C atom adjacent to the oxygen atom of the -O- bond (y = 1 and $R^2$ = $CH_3$), aka 5-methyloxolan-2-one.

In some preferred embodiments of the coated substrate, the vinylacetate has formula (III)

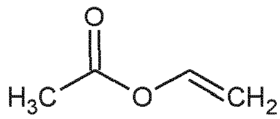

(III)

In some preferred embodiments of the coated substrate, the polyvinylpyrrolidone has a weight average molecular weight of ≥ 222 g/mol, more preferably in the range of from 2,500 to 2,500,000 g/mol, more preferably in the range of from 6,000 to 40,000 g/mol.

In some preferred embodiments of the coated substrate, the C5 to C8 alkyne is a straight or branched C5 to C8 alkyne, more preferably a straight chain C5 to C8 alkyne, which more preferably has formula (V)

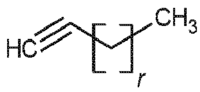

(V)

wherein r is an integer in the range of from 2 to 5, preferably r is 5.

In some preferred embodiments of the coated substrate, at least 80 weight-%, more preferably at least 90 weight-%, more preferably at least 95 weight-% of the compound used for depositing the coating are a compound of one of the groups as defined above, based on the total weight of all compounds used for depositing the coating, i.e. at least 80 weight-%, preferably at least 90 weight-%, more preferably at least 95 weight-% of the coating consists of a reaction product of a compound of one of the groups as described above.

In some embodiments, where the coating is made from vinylacetate, wherein preferably at least 80 weight-%, preferably at least 90 weight-%, more preferably at least 95 weight-% of the compound used for depositing the coating is vinylacetate, based on the total weight of all compounds used for depositing the coating, i.e. at least 80 weight-%, preferably at least 90 weight-%, more preferably at least 95 weight-% of the coating consists of a reaction product of vinylacetate, the reaction product is then in these embodiments at least partially hydrolysed to give vinylalcohol copolymer. The hydrolysis is in some embodiments done by exposing the coating comprising the reaction product of vinylacetate in a subsequent step, i.e. after step completion of the plasma-assisted deposition method, preferably after step (d) as described below, to a humid ammonia-containing atmosphere. For example, an aqueous solution of $NH_3$ having a concentration in the range of from 0.1 to 50 weight-%, preferably in the range of from 0.5 to 25 weight-%, ammonia in water, based on the aqueous solution having 100 weight-%, is presented at a temperature of 50 °C (and at a pressure of 1013 mbar) and the coating is exposed to the resulting atmosphere.

*Copolymers*

In some preferred embodiments of the coated substrate, a further compound is used for depositing the coating on the surface of the substrate by a plasma-assisted deposition method, which is selected from the group consisting of C2 to C4 alkene, C2 to C4 alkyne and mixtures thereof, more preferably from the group consisting of C3 to C4 alkene, C2 to C4 alkyne and mixtures thereof, preferably the compound used for depositing the coating on the surface of the substrate by a plasma-assisted deposition method comprises at least vinylacetate and the further compound is acetylene, more preferably the compound used for depositing the coating on the surface of the substrate by a plasma-assisted deposition method is vinylacetate and the further compound is acetylene.

In some preferred embodiments of the coated substrate, in the range of from 50 to 90 weight-%, more preferably in the range of from 80 to 90 weight-%, of the compound used for depositing the coating are a compound of one of the groups as described above, based on the total weight of all compounds used for depositing the coating and in the range of from 10 to 50 weight-%, preferably in the range of from 10 to 20 weight-%, are a further compound as defined above. In some embodiments where a further compound is used, a copolymer is formed from vinylacetate and one or more further compound(s) selected from C2 to C4 alkene, C2 to C4 alkyne and mixtures thereof. Said copolymer is then in some embodiments at least partially hydrolyzed to convert the part based on vinylacetate in the copolymer to vinylalcohol. In these embodiments where a further compound is used, at least 80 weight-%, preferably at least 90 weight-%, more preferably at least 95 weight-% of the compound used for depositing the coating are a compound of one of the above-identified groups and the further compound, preferably vinylacetate and one or more further compound(s) selected from C2 to C4 alkene, C2 to C4 alkyne and mixtures thereof, based on the total weight of all compounds used for depositing the coating, i.e. at least 80 weight-%, preferably at least 90 weight-%, more preferably at least 95 weight-% of the coating consists of a reaction product of a compound of one of the above-identified groups and the further compound, more preferably at least 90 weight-%, more preferably at least 95 weight-% of the coating consists of a reaction product of vinylacetate and one or more further compound(s) selected from C2 to C4 alkene, C2 to C4 alkyne and mixtures thereof. Hydrolysis is in some embodiments done by exposing the coating comprising the reaction product of vinylacetate and the one or more further compound(s) selected from C2 to C4 alkene, C2 to C4 alkyne and mixtures thereof in a subsequent step, i.e. after step completion of the plasma-assisted deposition method, preferably after step (d) as described below, to a humid ammonia containing atmosphere. For example, an aqueous solution of $NH_3$ having a concentration in the range of from 0.1 to 50 weight-%, preferably in the range of from 0.5 to 25 weight-%, ammonia in water, based on the aqueous solution having 100 weight-%, is presented at a temperature of 50 °C (and at a pressure of 1013 mbar) and the coating is exposed to the resulting atmosphere.

*State of the precursor*

In some preferred embodiments of the coated substrate, the fluorine-free compound is used as a precursor in the plasma-assisted deposition method in the form of a liquid phase, which comprises either a single compound in liquid state or a homogeneous solution in a liquid medium, wherein liquid means liquid at 25 °C and 1013 mbar. A liquid medium is a polar organic solvent except water. In some embodiments, the liquid medium is selected from the group consisting of C1 to C5 alkanols and their mixtures, preferably at least 95 weight-%, more preferably at least 98 weight-%, more preferably at least 99 weight-%, more preferably at least 99.5 weight-%, more preferably at least 99.9 weight-%, more preferably at least 99.95 weight-%, more preferably at least 99.99 weight-%, of the liquid medium are a polar organic solvents except water and their mixtures.

*Free of fluorine*

In some preferred embodiments of the coated substrate, the coating is substantially free of fluorine, more preferably the coating comprises less than 1 weight-%, more preferably less than 0.1 weight-%, of fluorine based on the total weight of the coating being 100 weight-%.

*Further properties of the coating*

In some preferred embodiments of the coated substrate, the retention time for toluene vapor is in the range of from 30 to 250 minutes, more preferably in the range of from 35 to 200 minutes, more preferably in the range of from 40 to 175 minutes, determined by Inverse Gas Chromatography (iGC) according to Reference Example 5.

In some preferred embodiments of the coated substrate, the monolayer binding capacity $q_{BET}$ is in the range of from 0.3 to 1.3 $\mu mol/cm^2$, preferably in the range of from 0.4 to 1.1 $\mu mol/cm^2$, more preferably in the range of from 0.5 to 0.8 $\mu mol/cm^2$, determined for toluene vapor by Inverse Gas Chromatography (iGC) according to Reference Example 5, and/or the BET constant $C_{BET}$ is in the range of from 50 to 300, preferably in the range of from 50 to 200,

more preferably in the range of from 70 to 175, determined by Inverse Gas Chromatography (iGC) for toluene vapor according to Reference Example 5. $q_{BET}$ describes the monolayer binding capacity, i.e. the number of binding sites for toluene on the investigated surface, and is expressed as molar amounts of adsorbed toluene molecules per unit of explored surface area in $\mu$mol/cm$^2$, whereas $C_{BET}$ indicates the strength of binding. Strong barrier against toluene vapor is reflected by low values for $q_{BET}$ and/or $C_{BET}$. $q_{BET}$ of the fluorine-free compounds according to the invention is in the same range as $q_{BET}$ of a comparative coating made from a fluorine-containing compound such as Freon R-134a or $F_2$ gas, which have $q_{BET}$ values of about 0.5 $\mu$mol/cm$^2$. Compared to an uncoated substrate, which has a $q_{BET}$ of about 1.6 $\mu$mol/cm$^2$, the monolayer capacity is improved (i.e. further reduced) by the coating with fluorine-free compounds according to the invention by at least 20 %, preferably by at least 30 %. $C_{BET}$ of the fluorine-free compounds according to the invention is in the same range as $C_{BET}$ of a comparative coating made from a fluorine-containing compound such as Freon R-134a or $F_2$ gas, which have $C_{BET}$ values in the range of from 70 to 90. It also has to be noted that the monolayer binding capacity $q_{BET}$ of, for example, plasma-assisted coatings based on epsilon-caprolactam ($q_{BET}$ = 0.53 $\mu$mol/cm$^2$), is completely comparable to a conventional barrier technology obtained by coextrusion of HDPE and PA-6 ($q_{BET}$ = 0.50 $\mu$mol/cm$^2$). Also $C_{BET}$ is comparable: plasma-assisted coatings based on epsilon-caprolactam have a $C_{BET}$ value of 74, while a PE/PA coextrudate has a $C_{BET}$ value of 80.

In some preferred embodiments of the coated substrate, the static contact angle against water for the fluorine-free compound being a lactam with 4 to 8 ring atoms, a lactone with 4 to 8 ring atoms, vinylacetate, or polyvinylpyrrolidone is in the range of from 10 to 46° determined according to Reference Example 2, whereas the static contact angle for a C5 to C8 alkyne against water is in the range of from 90 to 120° determined according to Reference Example 2, and/or the static contact angle against diiodomethane is in the range of from 10 to 40° for the fluorine-free compound being a lactam with 4 to 8 ring atoms, a lactone with 4 to 8 ring atoms, vinylacetate, or polyvinylpyrrolidone determined according to Reference Example 2, whereas the static contact angle for a C5 to C8 alkyne against diiodomethane is in the range of from 40 to 55° determined according to Reference Example 2, and/or the static contact angle against formamide for the fluorine-free compound being a lactam with 4 to 8 ring atoms, a lactone with 4 to 8 ring atoms, vinylacetate, or polyvinylpyrrolidone is in the range of from 8 to 15° determined according to Reference Example 2, whereas the static contact angle for a C5 to C8 alkyne against formamide is in the range of from 70 to 80° determined according to Reference Example 2.

In some preferred embodiments of the coated substrate, the surface free energy derived according to Reference Example 2 from static contact angles of water, formamide and diiodomethane is in the range of from 48 to 73 mN/m for the fluorine-free compound being a lactam with 4 to 8 ring atoms, a lactone with 4 to 8 ring atoms, vinylacetate, or polyvinylpyrrolidone, whereas the surface free energy derived according to Reference Example 2 from static contact angles of water, formamide and diiodomethane for a C5 to C8 alkyne is in the range of from 30 to 40 mN/m.

In some preferred embodiments of the coated substrate, the coating has a thickness in the range of from 20 to 500 nm, preferably in the range of from 50 to 350 nm, preferably determined by transmission electron microscopy (TEM) according to Reference Example 6.

In some preferred embodiments of the coated substrate, the coating comprising the reaction product of the fluorine-free compound is present on at least parts of the substrate's surface, preferably with a surface coverage determined by X-ray photoelectron spectroscopy (XPS) according to Reference Example 3 of at least 10 %, more preferred at least 20 %, more preferred at least 25 %, more preferred at least 30 %, of the area of the substrate's surface, which has been treated with the plasma-assisted deposition method.

In some preferred embodiments of the coated substrate, the reaction product of the fluorine-free compound comprised in the coating is a radical polymerization product (in contrast to polycondensation) as determined by Time-of-Flight Secondary Ion Mass Spectrometry (ToF-SIMS) according to Reference Example 4 as characterized by a shift of the nominal masses of the secondary ions by 2 amu that are created from such surface in comparison to the nominal masses of fragments that are created from the measurement of a polymer created by polycondensation.

*Intermediate acetylene-based layer*

In some preferred embodiments of the coated substrate, a layer comprising a reaction product of acetylene is present between the substrate's surface and the coating comprising a reaction product of the fluorine-free compound. In some preferred embodiments of the coated substrate, the layer comprising a reaction product of acetylene is obtained or obtainable from a plasma-assisted deposition of acetylene.

*Substrate*

In some preferred embodiments of the coated substrate, the substrate comprises a material selected from the group consisting of organic material and mixtures of organic material and inorganic material, wherein the organic material is preferably one or more organic polymer(s) and the inorganic material is preferably selected from the group consisting

of glass, silica, ceramics and steel.

In some preferred embodiments of the coated substrate, the substrate comprises an organic polymer selected from the group consisting of polyolefin, preferably polyethylene (PE) or polypropylene (PP); polyamide (PA); polyurethane (PU); fluorinated polymer; silicone; polycarbonate (PC); polymethylmethacrylate (PMMA); polyacrylate; polyesters, especially polyethylene terephthalate (PET); cellulose; cellulose-derived polymers like cellulose acetate, lignin, lignin-based composites including wood; and mixtures of two or more of these organic polymers.

In some preferred embodiments of the coated substrate, the substrate comprises an organic polymer selected from the group consisting of polyolefin, polyamide, polyester, and mixtures of two or more thereof, more preferred the substrate comprises an organic polymer selected from the group consisting of polyethylene, polyamide and mixtures of polyethylene and polyamide, more preferred the substrate comprises at least polyethylene (PE), more preferred high-density polyethylene (HDPE), more preferred at least 80 weight-%, more preferred at least 90 weight-%, more preferred at least 95 weight-%, more preferred at least 98 weight-% of the substrate consists of HDPE. High-density polyethylene (HDPE) has preferably a density in the range from 940 to 970 kg/$m^3$.

In some preferred embodiments of the coated substrate, the substrate is a packaging suitable for storing and transporting a good selected from the group consisting of food, beverage and chemical, wherein the chemical is preferably a hazardous substance (transported as dangerous good) or an agrochemical, wherein the coating is present on at least a surface of the substrate that faces or is intended for facing the good. A hazardous substance is a substance which has to be transported as dangerous goods according to ADR/RID (ADR = International Agreement concerning the International Carriage of Dangerous Goods by Road, RID = Regulations concerning the International Carriage of Dangerous Goods by Rail) and/or IMDG (International Maritime Dangerous Goods Code) and/or IATA (International Air Transport Association). The good is more preferably an agrochemical, and the substrate is more preferably an (agro)chemical container, wherein the coating is present on at least a surface of the substrate that faces or is intended for facing the (agro)chemical. For example, if the substrate is a container in which (agro)chemicals are to be filled in, the coating is present on at least a part of the inner surface of the container. In some preferred embodiments of the coated substrate, said coated substrate is an agrochemical container.

*Process steps and parameters - atmospheric plasma*

In some preferred embodiments of the coated substrate, the plasma-assisted deposition method comprises

(a) providing a substrate having a surface;
(b) generating a plasma under plasma-generating conditions by passing a carrier gas through an excitation zone and by applying high-frequency alternating current to an electrode positioned in the excitation zone to produce a dielectric barrier discharge thereby generating a plasma;
(c) generating an aerosol comprising a fluorine-free compound as defined above by using an atomizer gas;
(d) treating at least a part of the substrate surface provided according to (a) with the plasma generated according to (b) and the aerosol comprising the fluorine-free compound generated according to (c), thereby depositing a reaction product of the fluorine-free compound on the treated part of the substrate surface thereby obtaining a coated substrate.

In some preferred embodiments of the coated substrate, in the plasma-assisted deposition method, the plasma is generated in (a) at a pressure in the range from 0.5 to 1.5 bar, more preferably in the range from 0.8 to 1.2 bar (atmospheric or near-atmospheric conditions, indirect atmospheric pressure plasma processing), i.e. the plasma generated in (b) and used in (d) is an atmospheric plasma.

A "carrier gas" means typically a gas suitable for generating and maintaining a dielectric barrier discharge (DBD) plasma. In particular, the carrier gas is selected from the group consisting of $N_2$, Ar, He, $CO_2$, $O_2$, $N_2O$ or a mixture of two or more of these gases. The term "atomizer gas" typically means the gas used to nebulize or to create an aerosol in the atomizer as well as to transport the aerosol to and into the plasma. In particular, the atomizer gas is selected to be the same as the carrier gas.

In some embodiments, the plasma-assisted deposition method is preferably an indirect plasma treatment, for example, as in the PlasmaLine®, wherein the plasma is blown out from the zone between the electrodes where it is generated. Therein, the plasma according to (b) is preferably generated in a first zone, more preferred in a plasma discharge chamber; wherein preferably, the plasma is generated under plasma-generating conditions by passing a carrier gas through an excitation zone consisting of a grounded electrode and a high voltage electrode and by applying high frequency alternating current to the high voltage electrode to produce a dielectric barrier discharge thereby generating an atmospheric plasma. The aerosol comprising the at least one fluorine-free compound is generated according to (c) preferably in a second zone (atomizer zone), and the treatment according to (d) is preferably done in a third zone, which is more preferred a so-called afterglow chamber, which is positioned downstream of the plasma discharge chamber and

in fluid communication with an outlet of the plasma discharge chamber. The build-up of devices for such an indirect plasma treatment is known to a skilled person and is described, for example, in WO 2006/081637 A1 (Vito) or in Vangeneugden et al, "Atmospheric DBD plasma processes for production of lightweight composites" published at the 21st International Symposium on Plasma Chemistry (https://www.ispc-conference.org/ispcproc/ispc21/ID287.pdf). Normally, a transport means is provided for continuous transport of the substrate through the afterglow chamber and such that the substrate is kept remote from the plasma discharge chamber while being processed by plasma-activated species in the afterglow chamber. Alternatively, the plasma-assisted deposition method is a PlasmaSpot® (often called plasma jet) method, which also uses an indirect plasma treatment.

In some preferred embodiments of the coated substrate, step (c) of the plasma-assisted deposition method comprises

(c.1) providing the fluorine-free compound in liquid form in a vessel having an outlet;

(c.2) passing an atomizer gas through a nozzle so that the atomizer gas gets in contact with the fluorine-free compound at the outlet of the vessel, thereby generating an aerosol comprising the fluorine-free compound.

The vessel, in which the at least one fluorine-free compound in liquid form is provided, is not particularly limited with respect to its dimensions and/or its shape. In some embodiments, the vessel is a reservoir with a capillary therein, wherein the capillary is in contact with the liquid and protrudes from the vessel. The opening of the capillary at its side protruding from the vessel forms the outlet. In these embodiments, the atomizer gas coming from the nozzle -which has a specific diameter- passes almost horizontally along the outlet of the capillary, i.e. approximately vertically with respect to the capillary ("approximately vertically" means that the flow direction of the atomizer gas before passing the capillary and the capillary form an angle in the range from 45 to 135°, preferably an angle in the range from 75 to 105°, more preferred an angle in the range from 80 to 100°, more preferred in the range of from 85 to 95°, more preferred in the range from 88 to 92°), thus causing an underpressure within the outlet (Venturi effect), whereby liquid is sucked from the nozzle into the atomizer gas stream. The atomizer gas is preferably present in compressed form before passing the nozzle and expands after passing the nozzle. In some embodiments, a tube is arranged approximately vertically with respect to the atomizer gas stream, into which the atomizer gas enters through an opening after passing the outlet of the capillary ("approximately vertically" means that the flow direction of the atomizer gas before entering the tube through the opening and the tube form an angle in the range from 45 to 135°, preferably an angle in the range from 75 to 105°, more preferred an angle in the range from 80 to 100°, more preferred in the range of from 85 to 95°, more preferred in the range from 88 to 92°). The atomizer gas comprising the at least one fluorine-free compound in the form of liquid droplets of different sizes then collides with the inner wall of the tube, which is opposite to the opening. Thereby, larger droplets are removed, preferably by falling down in the tube, while the aerosol containing smaller droplets passes further through the tube, preferably in upwards direction. The aerosol which passes, preferably upwards, through the tube comprises the at least one fluorine-free compound in the form of liquid droplets, which have a specific size ranging from 1 to 1000 nm, preferably in the range from 5 to 400 nm, more preferred in the range from 10 to 200 nm.

The fluorine-free compound in embodiments with atmospheric plasma is preferably as defined above. More preferably, the fluorine-free compound is epsilon-caprolactam.

In embodiments related to the atmospheric plasma variant, the plasma according to (a) is preferably generated with a power per electrode area of less than 40 $kW/m^2$, more preferably with a power in the range from 7.5 to 38 $kW/m^2$, more preferred in the range from 8 to 30 $kW/m^2$. In embodiments related to the atmospheric plasma variant, one or more atomizers, preferably at least two atomizers are used, wherein the atomizer gas according to (c) or (c.2) is preferably provided into the second zone with a flow per atomizer of more than 0.5 slm (standard liter per minute), more preferably with a flow per atomizer in the range from 0.5 to 5 slm, more preferred in the range from 0.8 to 3 slm, more preferred in the range from 1 to 2 slm. In embodiments related to the atmospheric plasma variant, the amount of the fluorine-free compound transported as aerosol to and into the plasma per time is preferably in the range from 0.045 to 0.5 g/min per atomizer, more preferably in the range from 0.045 to 0.3 g/min per atomizer, more preferred in the range from 0.05 to 0.2 g/min per atomizer, more preferred in the range from 0.08 to 0.12 g/min per atomizer.

The amount of the at least one fluorine-free compound transported as aerosol to and into the plasma per time is also called the mass flow of the at least one fluorine-free compound transported as aerosol to and into the plasma. The mass flow is determined in that the amount of the at least one fluorine-free compound present in the second zone, preferably within a vessel in the second zone, is determined at a time to before the atomizer gas according to (c) is provided into the second zone, and the amount of the at least one fluorine-free compound in the second zone, preferably within the vessel in the second zone, is again determined after a time $t_1$ during which atomizer gas according to (c) has been provided into the second zone. The mass flow (mf) is determined according to

$$mf = [amount(t_0)-amount(t_1)]/[t_1-t_0]]$$

The mass flow can further be normalized to the applied plasma power, giving a power density-related mass flow in in the range from 0.001 to 0.02 (g*$m^2$)/(kW*min), preferably in the range from 0.003 to 0.015 ($gm^2$)/(kW*min), more preferred in the range from 0.005 to 0.012 (g*$m^2$)/(kW*min).

In embodiments related to the atmospheric plasma variant, the outlet of the excitation zone is preferably in a distance from the substrate surface according to (a) in the range from 0.5 to 10 mm, more preferably in the range from 0.5 to 5 mm, more preferred in the range from 2 to 4 mm, more preferred in the range from 2.5 to 3.5 mm. In embodiments related to the atmospheric plasma variant, in the plasma-assisted deposition method, the carrier gas is provided to the excitation zone preferably with a flow in the range from 50 to 500 l/min, more preferably in the range from 150 to 450 l/min, more preferred in the range from 200 to 300 l/min.

The plasma for use in the atmospheric plasma variant is a non-equilibrium plasma such as generated by alternating current (ac) discharge. Alternatively, the plasma is another non-equilibrium plasma such as those generated by radiofrequency (rf) excitation, microwave (mw) excitation, or direct current (dc) discharge.

In embodiments related to the atmospheric plasma variant, preferably alternating voltages up to 100 kV are applied, wherein the alternating voltage is more preferably in the range of 10 to 40 kV. In embodiments related to the atmospheric plasma variant, the discharge frequency is preferably in the range from 50 to 100 kHz, more preferably in the range from 60 to 100 kHz, more preferred in the range from 70 to 95 kHz, more preferred in the range from 80 to 90 kHz.

Preferably, the substrate is passed through the third zone (afterglow chamber) more than one time (number of passes > 1); preferably the number of passes is in the range from 5 to 100, more preferred in the range from 10 to 50. The speed, with which the substrate is passed is preferably in the range from 0.1 to 10 m/min, more preferred in the range from 1 to 3 m/min. In other embodiments, the substrate is passed through one or more, substantially identical third zones (afterglow chambers); preferably through x substantially identical third zones, wherein x is an integer from the range from 5 to 100, more preferred in the range from 10 to 50. The speed, with which the substrate is passed through each of the one or more or the x substantially identical third zones is preferably in the range from 0.1 to 10 m/min, more preferred in the range from 1 to 3 m/min. In embodiments related to the atmospheric plasma variant, the plasma-assisted deposition method is preferably carried out for a total time in the range of from 30 seconds to 10 minutes, more preferably in the range of from 1 to 2 minutes.

In embodiments related to the atmospheric plasma variant, the plasma-assisted deposition method is preferably carried out at a temperature in the range of from 10 to 80 °C.

*Process steps and parameters - low pressure plasma*

In some alternative preferred embodiments of the coated substrate, in the plasma-assisted deposition method, the plasma is generated at a pressure of <0.1 mbar, preferably in the range from 0.0001 to 0.09 mbar, preferably in the range from 0.001 to 0.05 mbar (low pressure plasma).

Preferably, in these alternative preferred embodiments related to low pressure plasma, the plasma-assisted deposition method comprises

(a) providing a substrate having a surface;
(b') generating an aerosol comprising a fluorine-free compound as defined above, preferably by using an atomizer gas;
(c') transforming the precursor aerosol generated in (b') into a plasma state by a combination of excitations comprising a main excitation by means of microwave-type electromagnetic waves, and a secondary excitation by means of an electric discharge of alternating voltage having a frequency between 1 kHz and 15 MHz, thereby generating a plasma;
(d') treating at least a part of the substrate surface provided according to (a) with the plasma generated according to (c'), thereby depositing a reaction product of the fluorine-free compound on the treated part of the substrate surface thereby obtaining a coated substrate.

As indicated above, the plasma generated in (c') is a lowpressure plasma. Preferably, the alternating voltage has a frequency between 10 and 200 kHz. Microwaves are electromagnetic waves with a frequency between 300 and 3000 MHz, preferably, a frequency between 915 and 2450 MHz.

Preferably, in these alternative preferred embodiments, step (c') of the plasma-assisted deposition method comprises

(c'.a) providing the fluorine-free compound in liquid form, optionally with application of heating, in a vessel having an outlet;
(c'.b) passing an atomizer gas through a nozzle so that the atomizer gas gets in contact with the fluorine-free compound at the outlet of the vessel, thereby generating an aerosol comprising the fluorine-free compound.

In alternative preferred embodiments related to low pressure plasma, the plasma-assisted deposition method comprises

(a) providing a substrate having a surface;
(b") providing an atmosphere comprising a fluorine-free compound in gaseous form or aerosol form, optionally under application of heating;
(c") generating a plasma from the atmosphere comprising the fluorine-free compound according to (b") under plasma-generating conditions by a combination of excitations comprising a main excitation by means of microwave-type electromagnetic waves, and a secondary excitation by means of an electric discharge of alternating voltage having a frequency between 1 kHz and 15 MHz, thereby generating a plasma;
(d") treating at least a part of the substrate surface provided according to (a) with the plasma generated according to (c"), thereby depositing a reaction product of the fluorine-free compound on the treated part of the substrate surface thereby obtaining a coated substrate.

The atmosphere comprises the fluorine-free compound and optionally one or more gases, preferably selected from the group consisting of $N_2$, Ar, He, $CO_2$, $O_2$, $N_2O$ or a mixture of two or more of these gases. The atmosphere comprising the fluorine-free compound in gaseous form or aerosol form is, for example, provided in that the fluorine-free compound, due to the vapor pressure it has in its liquid form, is partially gaseous and the gaseous phase is transferred to the vessel used for plasma generation and treatment, either in combination with a carrier gas or alone, or a liquid fluorine-free compound or a solution in a solvent of a liquid fluorine-free compound is injected into the vessel used for plasma generation and treatment.

For embodiments related to the low pressure variant without use of an atomizer gas (and without use of an aerosol), reference is made to US 2022/0112595 A1, where said process is described in detail, which is incorporated herein by reference, especially paragraphs [0010] to [0020], [0024] to [0028]. A suitable device is described in US 2022/0112595 A1 in paragraphs [0031] to [0060], which are also incorporated herein by reference.

In all embodiments where a low pressure plasma is used, the substrate to be coated, may it be the inner surface or parts thereof of a hollow container with an opening, the substrate is preferably placed in an enclosure, which is suitable for maintaining a specific pressure therein and the whole enclosure is evacuated.

In these embodiments related to the low pressure plasma variant, the fluorine-free compound is preferably selected from the group consisting of a lactam with 4 to 8 ring atoms, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam and excluding vinylpyrrolidone, a lactone with 4 to 8, preferably 6 to 8, ring atoms, vinylacetate, polyvinylpyrrolidone, and mixtures of two or more of these compounds, more preferably from the group consisting of a lactone with 4 to 8, preferably 6 to 8, ring atoms, vinylacetate, polyvinylpyrrolidone, and mixtures of two or more of these compounds, more preferably from the group consisting of a lactone with 4 to 8 ring atoms, vinylacetate, and mixtures of two or more of these compounds, more preferably the fluorine-free compound is a lactone with 4 to 8, preferably 6 to 8, ring atoms.

In some preferred embodiments of the coated substrate related to the low pressure plasma variant, a further compound is used for depositing the coating on the surface of the substrate by a plasma-assisted deposition method, which is selected from the group consisting of C2 to C4 alkene, C2 to C4 alkyne and mixtures thereof, more preferably from the group consisting of C3 to C4 alkene, C2 to C4 alkyne and mixtures thereof, preferably the compound used for depositing the coating on the surface of the substrate by a plasma-assisted deposition method comprises at least vinylacetate and the further compound is acetylene, more preferably the compound used for depositing the coating on the surface of the substrate by a plasma-assisted deposition method is vinylacetate and the further compound is acetylene.

In some preferred embodiments of the coated substrate related to the low pressure plasma variant, in the range of from 50 to 90 weight-%, more preferably in the range of from 80 to 90 weight-%, of the compound used for depositing the coating are a compound of one of the groups as described above, based on the total weight of all compounds used for depositing the coating and in the range of from 10 to 50 weight-%, preferably in the range of from 10 to 20 weight-%, are a further compound as defined above. In some embodiments where a further compound is used, a copolymer is formed from vinylacetate and one or more further compound(s) selected from C2 to C4 alkene, C2 to C4 alkyne and mixtures thereof. Said copolymer is then in some embodiments at least partially hydrolyzed to convert the part based on vinylacetate in the copolymer to vinylalcohol. In these embodiments where a further compound is used, at least 80 weight-%, preferably at least 90 weight-%, more preferably at least 95 weight-% of the compound used for depositing the coating are a compound of one of the above-identified groups and the further compound, preferably vinylacetate and one or more further compound(s) selected from C2 to C4 alkene, C2 to C4 alkyne and mixtures thereof, based on the total weight of all compounds used for depositing the coating, i.e. at least 80 weight-%, preferably at least 90 weight-%, more preferably at least 95 weight-% of the coating consists of a reaction product of a compound of one of the above-identified groups and the further compound, more preferably at least 90 weight-%, more preferably at least 95 weight-% of the coating consists of a reaction product of vinylacetate and one or more further compound(s) selected from C2 to C4 alkene, C2 to C4 alkyne and mixtures thereof. Hydrolysis is in some embodiments done by exposing the coating comprising the reaction product of vinylacetate and the one or more further compound(s) selected from C2 to C4 alkene, C2 to C4 alkyne and mixtures thereof in a subsequent step, i.e. after step completion of the plasma-assisted deposition method, preferably after step (d) as described below, to a humid ammonia containing atmosphere. For example, an aqueous solution of $NH_3$ having a concentration in the range of from 0.1 to 50 weight-%, preferably in the range of from 0.5 to 25 weight-%, ammonia in water, based on the aqueous solution having 100 weight-%, is presented at a temperature of 50 °C (and at a pressure of 1013 mbar) and the coating is exposed to the resulting atmosphere.

In some preferred embodiments of the coated substrate related to the low pressure plasma variant, a layer comprising a reaction product of acetylene is present between the substrate's surface and the coating comprising a reaction product of the fluorine-free compound. In some preferred embodiments of the coated substrate related to the low pressure plasma variant, the layer comprising a reaction product of acetylene is obtained or obtainable from a plasma-assisted deposition of acetylene.

In these embodiments related to the low pressure plasma variant, the power density of electromagnetic waves is in the range of from 0.01 to 1 $W/cm^3$ and/or the power of the electric discharge is in the range of from 4 to 30 W and the frequency is in the range of from 20 to 200 kHz.

In embodiments related to the low pressure plasma variant, the plasma-assisted deposition method is preferably carried out at a temperature in the range of from 10 to 80 °C. That is, "under application of heating" means that a temperature is established by suitable means in the range of from 10 to 80°C so that the fluorine-free compound can be provided in liquid form or gaseous form.

Irrespective whether an atmospheric plasma variant or a low pressure plasma variant is used in the plasma-assisted deposition method, preferably in none of steps (a), (b), (c), (d), more preferably at least not in step (d), water is added and/or the plasma-assisted deposition method, preferably at least step (d) thereof, is carried out in an atmosphere containing at the outmost as much water as contained in the atmosphere based on a relative humidity (RH) of 100 % at the respective process temperature.

## 2$^{nd}$ aspect of the invention - Process

The invention relates in a second aspect to a plasma-assisted deposition method for applying a coating onto a surface of a substrate comprising:

(a) providing a substrate having a surface;
(b) generating a plasma under plasma-generating conditions by passing a carrier gas through an excitation zone and by applying high-frequency alternating current to an electrode positioned in the excitation zone to produce a dielectric barrier discharge thereby generating a plasma;
(c) generating an aerosol comprising a fluorine-free compound as defined in any one of the embodiments described above for the first aspect of the invention by using an atomizer gas;
(d) treating at least a part of the substrate surface provided according to (a) with the plasma generated according to (b) and the aerosol comprising the fluorine-free compound generated according to (c), thereby depositing a reaction product of the fluorine-free compound on the treated part of the substrate surface thereby obtaining a coated substrate.

In some preferred embodiments of the plasma-assisted deposition method for applying a coating onto a surface of a substrate, step (c) of the plasma-assisted deposition method comprises

(c.1) providing the fluorine-free compound in liquid form in a vessel having an outlet;
(c.2) passing an atomizer gas through a nozzle so that the atomizer gas gets in contact with the fluorine-free compound at the outlet of the vessel, thereby generating an aerosol comprising the fluorine-free compound.

*Atmospheric plasma*

In some preferred embodiments of the plasma-assisted deposition method for applying a coating onto a surface of a substrate, the plasma is generated in (a) at a pressure in the range from 0.5 to 1.5 bar, preferably in the range from 0.8 to 1.2 bar (atmospheric or near-atmospheric conditions, indirect atmospheric pressure plasma processing).

In these embodiments of the plasma-assisted deposition method related to use of atmospheric plasma, the plasma according to (a) is preferably generated with a power per electrode area of less than 40 $kW/m^2$, more preferably

with a power in the range from 7.5 to 38 $kW/m^2$, more preferred in the range from 8 to 30 $kW/m^2$. In these embodiments of the plasma-assisted deposition method related to use of atmospheric plasma, one or more atomizers, preferably at least two atomizers are used, wherein the atomizer gas according to (c) or (c.2) is preferably provided into the second zone with a flow per atomizer of more than 0.5 slm (standard liter per minute), more preferably with a flow per atomizer in the range from 0.5 to 5 slm, more preferred in the range from 0.8 to 3 slm, more preferred in the range from 1 to 2 slm. In these embodiments of the plasma-assisted deposition method related to use of atmospheric plasma, the amount of the fluorine-free compound transported as aerosol to and into the plasma per time is in the range from 0.045 to 0.5 g/min per atomizer, more preferably in the range from 0.045 to 0.3 g/min per atomizer, more preferred in the range from 0.05 to 0.2 g/min per atomizer, more preferred in the range from 0.08 to 0.12 g/min per atomizer. In these embodiments of the plasma-assisted deposition method related to use of atmospheric plasma, the outlet of the excitation zone is preferably in a distance from the substrate surface according to (a) in the range from 0.5 to 10 mm, more preferably in the range from 0.5 to 5 mm, more preferred in the range from 2 to 4 mm, more preferred in the range from 2.5 to 3.5 mm. In these embodiments of the plasma-assisted deposition method related to use of atmospheric plasma, the carrier gas is provided to the excitation zone preferably with a flow in the range from 50 to 500 l/min, more preferably in the range from 150 to 450 l/min, more preferably in the range from 200 to 300 l/min. In these embodiments of the plasma-assisted deposition method related to use of atmospheric plasma, preferably alternating voltages up to 100 kV are applied, wherein the alternating voltage is more preferably in the range of 10 to 40 kV. In these embodiments of the plasma-assisted deposition method related to use of atmospheric plasma, the discharge frequency is preferably in the range from 50 to 100 kHz, preferably in the range from 60 to 100 kHz, more preferred in the range from 70 to 95 kHz, more preferred in the range from 80 to 90 kHz. In these embodiments of the plasma-assisted deposition method related to use of atmospheric plasma, the plasma-assisted deposition method is preferably carried out at a temperature in the range of from 10 to 80 °C. In these embodiments of the plasma-assisted deposition method related to use of atmospheric plasma, the plasma-assisted deposition method is preferably carried out for a total time in the range of from 30 seconds to 10 minutes, more preferably in the range of from 1 to 2 minutes.

*Low pressure plasma*

In some alternative preferred embodiments of the plasma-assisted deposition method for applying a coating onto a surface of a substrate, the plasma is generated at a pressure of <0.1 mbar, preferably in the range from 0.0001 to 0.09 mbar, preferably in the range from 0.001 to 0.05 mbar (low pressure plasma).

In these alternative preferred embodiments related to low pressure plasma, the plasma-assisted deposition method according to one variant preferably comprises

(a) providing a substrate having a surface;
(b') generating an aerosol comprising a fluorine-free compound as defined in any one of the embodiments related to the first aspect of the invention described above by using an atomizer gas;
(c') transforming the precursor aerosol generated in (b') into a plasma state by a combination of excitations comprising a main excitation by means of microwave-type electromagnetic waves, and a secondary excitation by means of an electric discharge of alternating voltage having a frequency between 1 kHz and 15 MHz, thereby generating a plasma;
(d') treating at least a part of the substrate surface provided according to (a) with the plasma generated according to (c'), thereby depositing a reaction product of the fluorine-free compound on the treated part of the substrate surface thereby obtaining a coated substrate.

As indicated above, the plasma generated in (c) is a low pressure plasma. Preferably, alternating voltage has a frequency between 10 and 200 kHz. Microwaves are electromagnetic waves with a frequency between 300 and 3000 MHz, preferably, a frequency between 915 and 2450 MHz.

In these alternative preferred embodiments related to low pressure plasma, step (c) of the plasma-assisted deposition method according to one variant comprises

(c'.a) providing the fluorine-free compound in liquid form, optionally with application of heating, in a vessel having an outlet;
(c'.b) passing an atomizer gas through a nozzle so that the atomizer gas gets in contact with the fluorine-free compound at the outlet of the vessel, thereby generating an aerosol comprising the fluorine-free compound.

In alternative preferred embodiments related to low pressure plasma, the plasma-assisted deposition method according to another variant the plasma-assisted deposition method comprises

(a) providing a substrate having a surface;

(b") providing an atmosphere comprising a fluorine-free compound in gaseous form or aerosol form, optionally under application of heating;

(c") generating a plasma from the atmosphere comprising the fluorine-free compound according to (b.1) under plasma-generating conditions by a combination of excitations comprising a main excitation by means of microwave-type electromagnetic waves, and a secondary excitation by means of an electric discharge of alternating voltage having a frequency between 1 kHz and 15 MHz, thereby generating a plasma;

(d") treating at least a part of the substrate surface provided according to (a) with the plasma generated according to (c"), thereby depositing a reaction product of the fluorine-free compound on the treated part of the substrate surface thereby obtaining a coated substrate.

The atmosphere comprises the fluorine-free compound and optionally one or more gases, preferably selected from the group consisting of $N_2$, Ar, He, $CO_2$, $O_2$, $N_2O$ or a mixture of two or more of these gases. The atmosphere comprising a fluorine-free compound in gaseous form or aerosol form is for example, provided in that the fluorine-free compound, due to the vapor pressure it has in its liquid form is partially gaseous and the gaseous phase is transferred to the vessel used for plasma generation and treatment, either in combination with a carrier gas or alone, or a liquid fluorine-free compound or a solution in a solvent of a liquid fluorine-free compound is injected into the vessel used for plasma generation and treatment.

For embodiments related to the low pressure variant without use of an atomizer gas (and without use of an aerosol), reference is made to US 2022/0112595 A1, where said process is described in detail, which is incorporated herein by reference, especially paragraphs [0010] to [0020], [0024] to [0028]. A suitable device is described in US 2022/0112595 A1 in paragraphs [0031] to [0060], which are also incorporated herein by reference.

In all embodiments where a low pressure plasma is used, the substrate to be coated, may it be the inner surface or parts thereof of a hollow container with an opening, the substrate is preferably placed in an enclosure, which is suitable for maintaining a specific pressure therein and the whole enclosure is evacuated.

In all embodiments where a low pressure plasma is used, the fluorine-free compound is preferably selected from the group consisting of a lactam with 4 to 8 ring atoms, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam and excluding vinylpyrrolidone, a lactone with 4 to 8, preferably 6 to 8, ring atoms, vinylacetate, polyvinylpyrrolidone, and mixtures of two or more of these compounds, more preferably from the group consisting of a lactone with 4 to 8, preferably 6 to 8, ring atoms, vinylacetate, polyvinylpyrrolidone, and mixtures of two or more of these compounds, more preferably from the group consisting of a lactone with 4 to 8 ring atoms, vinylacetate, and mixtures of two or more of these compounds, more preferably the fluorine-free compound is a lactone with 4 to 8, preferably 6 to 8, ring atoms.

In all embodiments where a low pressure plasma is used, the power density of electromagnetic waves is in the range of from 0.01 to 1 $W/cm^3$ and/or the power of the electric discharge is in the range of from 4 to 30 W and the frequency is in the range of from 20 to 200 kHz.

"Under application of heating" means that a temperature is established by suitable means in the range of from 10 to 80°C so that the fluorine-free compound can be provided in liquid form or gaseous form.

Irrespective whether an atmospheric plasma or a low pressure plasma is used in the plasma-assisted deposition method for applying a coating onto a surface of a substrate, preferably in none of steps (a), (b), (c), (d), more preferably at least not in step (d), water is added and/or wherein the plasma-assisted deposition method, preferably at least step (d) thereof, is carried out in an atmosphere containing at the outmost as much water as contained in the atmosphere based on a relative humidity (RH) of 100 % at the respective process temperature.

Irrespective whether an atmospheric plasma or a low pressure plasma is used in the plasma-assisted deposition method for applying a coating onto a surface of a substrate, the substrate comprises a material selected from the group consisting of organic material and mixtures of organic material and inorganic material, wherein the organic material is preferably one or more organic polymer(s) and the inorganic material is preferably selected from the group consisting of glass, silica, ceramics and steel. The organic polymer is preferably selected from the group consisting of polyolefin, preferably polyethylene (PE) or polypropylene (PP); polyamide (PA); polyurethane (PU); fluorinated polymer; silicone; polycarbonate (PC); polymethylmethacrylate (PMMA); polyacrylate; polyesters, especially polyethylene terephthalate (PET); cellulose; cellulose-derived polymers like cellulose acetate, lignin, lignin-based composites including wood; and mixtures of two or more of these organic polymers.

Irrespective whether an atmospheric plasma or a low pressure plasma is used in the plasma-assisted deposition method for applying a coating onto a surface of a substrate, the substrate more preferably comprises an organic polymer selected from the group consisting of polyolefin, polyamide, polyester, and mixtures of two or more thereof, more preferred the substrate comprises an organic polymer selected from the group consisting of polyethylene, polyamide and mixtures

of polyethylene and polyamide, more preferred the substrate comprises at least polyethylene (PE), more preferred high-density polyethylene (HDPE).

Regarding properties of the coated substrate obtained, reference is made to the disclosure hereinabove related to the first aspect of the present invention, i.e. the properties of the coated substrate obtained are as disclosed in detail in the section above directed to the first aspect. Further, preferred embodiments of the method, as well as process parameters, are as disclosed in detail above with respect to the first aspect. Furthermore, the details disclosed above with respect to the first aspect regarding for example the atmospheric plasma variant and the low pressure variant apply also for the plasma-assisted deposition method of the second aspect.

**3rd aspect of the invention - use**

A third aspect of the invention relates to the use of a coated substrate as described above with respect to the first aspect or of a coated substrate obtained or obtainable from the plasma-assisted deposition method of the second aspect as described above, for packaging, storing and/or transporting a good selected from the group consisting of food, beverage and chemical wherein the good is preferably a chemical, wherein the chemical is preferably a hazardous substance (transported as dangerous good) or an agrochemical, more preferably an agrochemical.

The present invention is further illustrated by the following embodiments and combinations of embodiments as indicated by the respective dependencies and back-references. In particular, it is noted that in each instance where a range of embodiments is mentioned, for example in the context of a term such as "The ... of any of embodiments 1 to 4", every embodiment in this range is meant to be explicitly disclosed for the skilled person, i.e. the wording of this term is to be understood by the skilled person as being synonymous to "The ... of any of embodiments 1, 2, 3, and 4".

1. A coated substrate, wherein the coating is obtained or obtainable from depositing on a surface of a substrate by a plasma-assisted deposition method a reaction product of a fluorine-free compound selected from the group consisting of a lactam with 4 to 8 ring atoms, a lactone with 4 to 8 ring atoms, vinylacetate, polyvinylpyrrolidone, C5 to C8 alkyne and mixtures of two or more of these compounds.

2. The coated substrate of embodiment 1, wherein the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate, polyvinylpyrrolidone, C5 to C8 alkyne and mixtures of two or more of these compounds.

3. The coated substrate of embodiment 1 or 2, wherein the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate, C5 to C8 alkyne and mixtures of two or more of these compounds.

4. The coated substrate of any one of embodiments 1 to 3, wherein the compound used for depositing the coating on the surface of the substrate by a plasma-assisted deposition method is selected from the group consisting of a lactam with 4 to 8 ring atoms excluding vinylpyrrolidone, a lactone with 4 to 8 ring atoms, vinylacetate and mixtures of two or more of these compounds, preferably selected from the group consisting of a lactone with 4 to 8 ring atoms, vinylacetate and mixtures of two or more of these compounds.

5. The coated substrate of any one of embodiments 1 to 4, wherein the lactam with 4 to 8 ring atoms has formula (I)

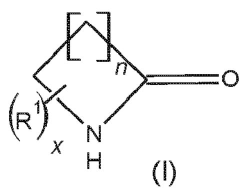
(I)

wherein

- $R^1$ is a vinyl group,
- x is zero or 1, and
- n is an integer in the range of from 2 to 5, preferably in the range of from 2 to 4, more preferably n is 4 and x is zero (epsilon-caprolactam) and/ or n is 2 and x is 1, wherein $R^1$ is a vinyl group substituting the hydrogen

atom at the nitrogen of the ring structure (vinylpyrrolidone).

6. The coated substrate of any one of embodiments 1 to 5, wherein the lactone with 4 to 8 ring atoms, preferably 6 to 8 ring atoms, has formula (II)

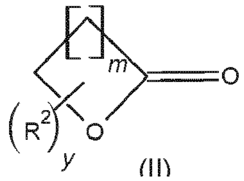

(II)

wherein

$R^2$ is selected from methyl group and vinyl group,
y is zero or 1, and

m is an integer in the range of from 1 to 5, preferably in the range of from 3 to 4, wherein the lactone is more preferably selected from the group consisting of delta-valerolactone, gamma-valerolactone, epsilon-caprolactone, and mixtures of two or more of these lactones, more preferably the lactone comprises at least, more preferably is, gamma-valerolactone.

7. The coated substrate of any one of embodiments 1 to 6, wherein vinylacetate has formula (III)

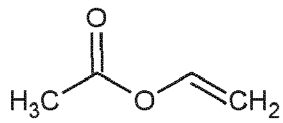

(III)

8. The coated substrate of any one of embodiments 1 to 7, wherein the polyvinylpyrrolidone has a weight average molecular weight of ≥ 222 g/mol, preferably in the range of from 2,500 to 2,500,000 g/mol, more preferably in the range of from 6,000 to 40,000 g/mol.

9. The coated substrate of any one of embodiments 1 to 8, wherein the C5 to C8 alkyne is a straight or branched C5 to C8 alkyne, preferably a straight chain C5 to C8 alkyne, which more preferably has formula (V)

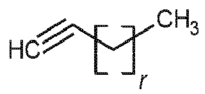

(V)

wherein r is an integer in the range of from 2 to 5, preferably r is 5.

10. The coated substrate of any one of embodiments 1 to 9, wherein at least 80 weight-%, preferably at least 90 weight-%, more preferably at least 95 weight-% of the compound used for depositing the coating are a compound of one of the groups according to embodiments 1 to 9, based on the total weight of all compounds used for depositing the coating, i.e. at least 80 weight-%, preferably at least 90 weight-%, more preferably at least 95 weight-% of the coating consists of a reaction product of a compound of one of the groups according to embodiments 1 to 9.

11. The coated substrate of any one of embodiments 1 to 10, wherein a further compound is used for depositing the coating on the surface of the substrate by a plasma-assisted deposition method, which is selected from the group consisting of, C2 to C4 alkene, C2 to C4 alkyne and mixtures thereof, more preferably from the group consisting of C3 to C4 alkene, C2 to C4 alkyne and mixtures thereof, preferably the compound used for depositing the coating on the surface of the substrate by a plasma-assisted deposition method comprises at least vinylacetate and the

further compound is acetylene, more preferably the compound used for depositing the coating on the surface of the substrate by a plasma-assisted deposition method is vinylacetate and the further compound is acetylene.

12. The coated substrate of embodiments 1 to 11, wherein in the range of from 50 to 90 weight-%, preferably in the range of from 80 to 90 weight-%, of the compound used for depositing the coating are a compound of one of the groups according to embodiments 1 to 9, based on the total weight of all compounds used for depositing the coating and in the range of from 10 to 50 weight-%, preferably in the range of from 10 to 20 weight-%, are a further compound according to embodiment 11.

13. The coated substrate of any one of embodiments 1 to 12, wherein the fluorine-free compound is used as a precursor in the plasma-assisted deposition method in the form of a liquid phase, which comprises either a single compound in liquid state or a homogeneous solution in a liquid medium.

14. The coated substrate of any one of embodiments 1 to 13, wherein the coating is substantially free of fluorine, preferably the coating comprises less than 1 weight-%, more preferably less than 0.1 weight-%, of fluorine based on the total weight of the coating being 100 weight-%.

15. The coated substrate of any one of embodiments 1 to 14, wherein the monolayer binding capacity ($q_{BET}$) is in the range of from 0.3 to 1.3 $\mu$mol/cm$^2$, preferably in the range of from 0.4 to 1.1 $\mu$mol/cm$^2$, more preferably in the range of from 0.5 to 0.8 $\mu$mol/cm$^2$, determined for toluene vapor by Inverse Gas Chromatography (iGC) according to Reference Example 5.

16. The coated substrate of any one of embodiments 1 to 15, wherein the retention time ($t_{R,end}$) for toluene vapor is in the range 30 to 250 minutes, more preferably in the range of from 35 to 200 minutes, more preferably in the range of from 40 to 175 minutes, determined by Inverse Gas Chromatography (iGC) according to Reference Example 5.

17. The coated substrate of any one of embodiments 1 to 16, wherein the BET constant ($C_{BET}$) is in the range of from 50 to 300, preferably in the range of from 50 to 200, more preferably in the range of from 70 to 175, determined for toluene vapor by Inverse Gas Chromatography (iGC) according to Reference Example 5.

18. The coated substrate of any one of embodiments 1 to 17, wherein the static contact angle against water for a fluorine-free compound being a lactam with 4 to 8 ring atoms, a lactone with 4 to 8 ring atoms, vinylacetate, or polyvinylpyrrolidone is in the range of from 10 to 46° determined according to Reference Example 2, whereas the static contact angle for a C5 to C8 alkyne against water is in the range of from 90 to 120° determined according to Reference Example 2, and/or the static contact angle against diiodomethane is in the range of from 10 to 40° or a fluorine-free compound being a lactam with 4 to 8 ring atoms, a lactone with 4 to 8 ring atoms, vinylacetate, or polyvinylpyrrolidone determined according to Reference Example 2, whereas the static contact angle for a C5 to C8 alkyne against diiodomethane is in the range of from 40 to 55° determined according to Reference Example 2, and/or the static contact angle against formamide for a fluorine-free compound being a lactam with 4 to 8 ring atoms, a lactone with 4 to 8 ring atoms, vinylacetate, or polyvinylpyrrolidone is in the range of from 8 to 15° determined according to Reference Example 2, whereas the static contact angle for a C5 to C8 alkyne against formamide is in the range of from 70 to 80° determined according to Reference Example 2.

19. The coated substrate of any one of embodiments 1 to 18, wherein the surface free energy derived according to Reference Example 2 from static contact angles of water, formamide and diiodomethane is in the range of from 48 to 73 mN/m for a fluorine-free compound being a lactam with 4 to 8 ring atoms, a lactone with 4 to 8 ring atoms, vinylacetate, or polyvinylpyrrolidone, whereas the surface free energy derived according to Reference Example 2 from static contact angles of water, formamide and diiodomethane for a C5 to C8 alkyne is in the range of from 30 to 40 mN/m .

20. The coated substrate of any one of embodiments 1 to 19, wherein the coating has a thickness in the range of from 20 to 500 nm, preferably in the range of from 50 to 350 nm, preferably determined by transmission electron microscopy (TEM) according to Reference Example 6.

21. The coated substrate of any one of embodiments 1 to 20, wherein the coating comprising the reaction product of the fluorine-free compound is present on at least parts of the substrate’s surface, preferably with a surface coverage determined by X-ray photoelectron spectroscopy (XPS) according to Reference Example 3 of at least 10

%, more preferred at least 20 %, more preferred at least 25 %, more preferred at least 30 %, of the area of the substrate's surface, which has been treated with the plasma-assisted deposition method.

22. The coated substrate of any one of embodiments 1 to 21, wherein the reaction product of the fluorine-free compound comprised in the coating is a radical polymerization product (in contrast to polycondensation) as determined by Time-of-Flight Secondary Ion Mass Spectrometry (ToF-SIMS) according to Reference Example 4 as characterized by a shift of the nominal masses of the secondary ions by 2 amu that are created from such surface in comparison to the nominal masses of fragments that are created from the measurement of a polymer created by polycondensation.

23. The coated substrate of any one of embodiments 1 to 22, wherein a layer comprising a reaction product of acetylene is present between the substrate's surface and the coating comprising a reaction product of the fluorine-free compound.

24. The coated substrate of embodiment 23, wherein the layer comprising a reaction product of acetylene is obtained or obtainable from a plasma-assisted deposition of acetylene.

25. The coated substrate of any one of embodiments 1 to 24, wherein the substrate comprises a material selected from the group consisting of organic material and mixtures of organic material and inorganic material, wherein the organic material is preferably one or more organic polymer(s) and the inorganic material is preferably selected from the group consisting of glass, silica, ceramics and steel.

26. The coated substrate of any one of embodiments 1 to 25, wherein the substrate comprises an organic polymer selected from the group consisting of polyolefin, preferably polyethylene (PE) or polypropylene (PP); polyamide (PA); polyurethane (PU); fluorinated polymer; silicone; polycarbonate (PC); polymethylmethacrylate (PMMA); polyacrylate; polyesters, especially polyethylene terephthalate (PET); cellulose; cellulose-derived polymers like cellulose acetate, lignin, lignin-based composites including wood; and mixtures of two or more of these organic polymers.

27. The coated substrate of any one of embodiments 1 to 26, wherein the substrate comprises an organic polymer selected from the group consisting of polyolefin, polyamide, polyester, and mixtures of two or more thereof, more preferred the substrate comprises an organic polymer selected from the group consisting of polyethylene, polyamide and mixtures of polyethylene and polyamide, more preferred the substrate comprises at least polyethylene (PE), more preferred high-density polyethylene (HDPE), more preferred at least 80 weight-%, more preferred at least 90 weight-%, more preferred at least 95 weight-%, more preferred at least 98 weight-% of the substrate consists of HDPE.

28. The coated substrate of any one of embodiments 1 to 27, wherein the substrate is a packaging suitable for storing and transporting a good selected from the group consisting of food, beverage and chemical, wherein the chemical is preferably a hazardous substance (transported as dangerous good) or an agrochemical, wherein the coating is present on at least a surface of the substrate that faces or is intended for facing the good, wherein the good is more preferably an agrochemical, and the substrate is more preferably an (agro)chemical container, wherein the coating is present on at least a surface of the substrate that faces or is intended for facing the (agro)chemical

29. The coated substrate of any one of embodiments 1 to 28, which is an agrochemical container.

30. The coated substrate of any one of embodiments 1 to 29, wherein in the plasma-assisted deposition method, the plasma is generated in (a) at a pressure in the range from 0.5 to 1.5 bar, preferably in the range from 0.8 to 1.2 bar (atmospheric or near-atmospheric conditions, indirect atmospheric pressure plasma processing).

31. The coated substrate of any one of embodiment 30, wherein the plasma-assisted deposition method comprises

(a) providing a substrate having a surface;
(b) generating a plasma under plasma-generating conditions by passing a carrier gas through an excitation zone and by applying high-frequency alternating current to an electrode positioned in the excitation zone to produce a dielectric barrier discharge thereby generating a plasma;
(c) generating an aerosol comprising a fluorine-free compound as defined in any one of embodiments 1 to 11 by using an atomizer gas;
(d) treating at least a part of the substrate surface provided according to (a) with the plasma generated according to (b) and the aerosol comprising the fluorine-free compound generated according to (c), thereby depositing a

reaction product of the fluorine-free compound on the treated part of the substrate surface thereby obtaining a coated substrate.

32. The coated substrate of embodiment 30 or 31, wherein step (c) of the plasma-assisted deposition method comprises

(c.1) providing the fluorine-free compound in liquid form in a vessel having an outlet;
(c.2) passing an atomizer gas through a nozzle so that the atomizer gas gets in contact with the fluorine-free compound at the outlet of the vessel, thereby generating an aerosol comprising the fluorine-free compound.

33. The coated substrate of any one of embodiments 1 to 29, wherein in the plasma-assisted deposition method, the plasma is generated at a pressure of <0.1 mbar, preferably in the range from 0.0001 to 0.09 mbar, preferably in the range from 0.001 to 0.05 mbar (low pressure plasma).

34. The coated substrate of embodiment 33, wherein the plasma-assisted deposition method comprises

(a) providing a substrate having a surface;
(b') generating an aerosol comprising a fluorine-free compound as defined in any one of embodiments 1 to 11, preferably by using an atomizer gas;
(c') transforming the precursor aerosol generated in (b') into a plasma state by a combination of excitations comprising a main excitation by means of microwave-type electromagnetic waves, and a secondary excitation by means of an electric discharge of alternating voltage having a frequency between 1 kHz and 15 MHz, thereby generating a plasma;
(d') treating at least a part of the substrate surface provided according to (a) with the plasma generated according to (c'), thereby depositing a reaction product of the fluorine-free compound on the treated part of the substrate surface thereby obtaining a coated substrate.

35. The coated substrate of embodiment 34, wherein step (c.1) of the plasma-assisted deposition method comprises

(c'.a) providing the fluorine-free compound in liquid form, optionally with application of heating, in a vessel having an outlet;
(c'.b) passing an atomizer gas through a nozzle so that the atomizer gas gets in contact with the fluorine-free compound at the outlet of the vessel, thereby generating an aerosol comprising the fluorine-free compound.

36. The coated substrate of embodiment 33, wherein the plasma-assisted deposition method comprises

(a) providing a substrate having a surface;
(b") providing an atmosphere comprising a fluorine-free compound in gaseous form or aerosol form, optionally under application of heating;
(c") generating a plasma from the atmosphere comprising the fluorine-free compound according to (b") under plasma-generating conditions a combination of excitations comprising a main excitation by means of microwave-type electromagnetic waves, and a secondary excitation by means of an electric discharge of alternating voltage having a frequency between 1 kHz and 15 MHz, thereby generating a plasma;
(d") treating at least a part of the substrate surface provided according to (a) with the plasma generated according to (c"), thereby depositing a reaction product of the fluorine-free compound on the treated part of the substrate surface thereby obtaining a coated substrate.

37. The coated substrate of any one of embodiments 33 to 36, wherein the fluorine-free compound is preferably selected from the group consisting of a lactam with 4 to 8 ring atoms, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam and excluding vinylpyrrolidone, a lactone with 4 to 8, preferably 6 to 8, ring atoms, vinylacetate, polyvinylpyrrolidone, and mixtures of two or more of these compounds, more preferably from the group consisting of a lactone with 4 to 8, preferably 6 to 8, ring atoms, vinylacetate, polyvinylpyrrolidone, and mixtures of two or more of these compounds, more preferably from the group consisting of a lactone with 4 to 8 ring atoms, vinylacetate, and mixtures of two or more of these compounds, more preferably the fluorine-free compound is a lactone with 4 to 8, preferably 6 to 8, ring atoms.

38. The coated substrate of any one of embodiments 30 to 32, wherein in the plasma-assisted deposition method, the plasma according to (a) is generated with a power per electrode area of less than 40 $kW/m^2$, preferably with a power in the range from 7.5 to 38 $kW/m^2$, more preferred in the range from 8 to 30 $kW/m^2$.

39. The coated substrate of any one of embodiments 30 to 32 and 38, wherein in the plasma-assisted deposition method, one or more atomizers, preferably at least two atomizers are used, wherein the atomizer gas according to (c) or (c.2) is provided into the second zone with a flow per atomizer of more than 0.5 slm (standard liter per minute), preferably with a flow per atomizer in the range from 0.5 to 5 slm, more preferred in the range from 0.8 to 3 slm, more preferred in the range from 1 to 2 slm.

40. The coated substrate of any one of embodiments 30 to 32 and 38 to 39, wherein in the plasma-assisted deposition method, the amount of the fluorine-free compound transported as aerosol to and into the plasma per time is in the range from 0.045 to 0.5 g/min per atomizer, preferably in the range from 0.045 to 0.3 g/min per atomizer, more preferred in the range from 0.05 to 0.2 g/min per atomizer, more preferred in the range from 0.08 to 0.12 g/min per atomizer.

41. The coated substrate of any one of embodiments 30 to 32 and 38 to 40, wherein in the plasma-assisted deposition method, the outlet of the excitation zone is in a distance from the substrate surface according to (a) in the range from 0.5 to 10 mm, preferably in the range from 0.5 to 5 mm, more preferred in the range from 2 to 4 mm, more preferred in the range from 2.5 to 3.5 mm.

42. The coated substrate of any one of embodiments 30 to 32 and 38 to 41, wherein in the plasma-assisted deposition method, the carrier gas is provided to the excitation zone with a flow in the range from 50 to 500 l/min, preferably in the range from 150 to 450 l/min, more preferred in the range from 200 to 300 l/min.

43. The coated substrate of any one of embodiments 30 to 32 and 38 to 42, wherein in the plasma-assisted deposition method, alternating voltages up to 100 kV are applied, wherein the alternating voltage is preferably in the range of 10 to 40 kV.

44. The coated substrate of any one of embodiments 30 to 32 and 38 to 43, wherein in the plasma-assisted deposition method, the discharge frequency is in the range from 50 to 100 kHz, preferably in the range from 60 to 100 kHz, more preferred in the range from 70 to 95 kHz, more preferred in the range from 80 to 90 kHz.

45. The coated substrate of any one of embodiments 30 to 32 and 38 to 44, wherein the plasma-assisted deposition method is carried out for a total time in the range of from 30 seconds to 10 minutes, preferably in the range of from 1 to 2 minutes.

46. The coated substrate of any one of embodiments 33 to 37, wherein the power density of electromagnetic waves is in the range of from 0.01 to 1 $W/cm^3$ and/or the power of the electric discharge is in the range of from 4 to 30 W and the frequency is in the range of from 20 to 200 kHz.

47. The coated substrate of any one of embodiments 30 to 46 wherein the plasma-assisted deposition method is carried out at a temperature in the range of from 10 to 80 °C.

48. The coated substrate of any one of embodiments 30 to 47, wherein in the plasma-assisted deposition method, preferably in none of steps (a), (b), (c), (d), more preferably at least not in step (d), water is added and/or wherein the plasma-assisted deposition method, preferably at least step (d) thereof, is carried out in an atmosphere containing at the outmost as much water as contained in the atmosphere based on a relative humidity (RH) of 100 % at the respective process temperature.

49. A plasma-assisted deposition method for applying a coating onto a surface of a substrate comprising:

(a) providing a substrate having a surface;
(b) generating a plasma under plasma-generating conditions by passing a carrier gas through an excitation zone and by applying high-frequency alternating current to an electrode positioned in the excitation zone to produce a dielectric barrier discharge thereby generating a plasma;
(c) generating an aerosol comprising a fluorine-free compound as defined in any one of embodiments 1 to 11, preferably by using an atomizer gas;

d) treating at least a part of the substrate surface provided according to (a) with the plasma generated according to (b) and the aerosol comprising the fluorine-free compound generated according to (c), thereby depositing a reaction product of the fluorine-free compound on the treated part of the substrate surface thereby obtaining a coated substrate.

50. The plasma-assisted deposition method for applying a coating onto a surface of a substrate according to embodiment 49, wherein step (c) of the plasma-assisted deposition method comprises

(c.1) providing the fluorine-free compound in liquid form in a vessel having an outlet;
(c.2) passing an atomizer gas through a nozzle so that the atomizer gas gets in contact with the fluorine-free compound at the outlet of the vessel, thereby generating an aerosol comprising the fluorine-free compound.

51. The plasma-assisted deposition method for applying a coating onto a surface of a substrate according to embodiment 49 or 50, wherein the plasma is generated in (a) at a pressure in the range from 0.5 to 1.5 bar, preferably in the range from 0.8 to 1.2 bar (atmospheric or near-atmospheric conditions, indirect atmospheric pressure plasma processing).

52. The plasma-assisted deposition method for applying a coating onto a surface of a substrate according to any one of embodiments 49 to 51, wherein the plasma according to (a) is generated with a power per electrode area of less than 40 $kW/m^2$, preferably with a power in the range from 7.5 to 38 $kW/m^2$, more preferred in the range from 8 to 30 $kW/m^2$.

53. The plasma-assisted deposition method for applying a coating onto a surface of a substrate according to any one of embodiments 49 to 52, wherein one or more atomizers, preferably at least two atomizers are used, wherein the atomizer gas according to (c) or (c.2) is provided into the second zone with a flow per atomizer of more than 0.5 slm (standard liter per minute), preferably with a flow per atomizer in the range from 0.5 to 5 slm, more preferred in the range from 0.8 to 3 slm, more preferred in the range from 1 to 2 slm.

54. The plasma-assisted deposition method for applying a coating onto a surface of a substrate according to any one of embodiments 49 to 53, wherein the amount of the fluorine-free compound transported as aerosol to and into the plasma per time is in the range from 0.045 to 0.5 g/min per atomizer, preferably in the range from 0.045 to 0.3 g/min per atomizer, more preferred in the range from 0.05 to 0.2 g/min per atomizer, more preferred in the range from 0.08 to 0.12 g/min per atomizer.

55. The plasma-assisted deposition method for applying a coating onto a surface of a substrate according to any one of embodiments 49 to 54, wherein the outlet of the excitation zone is in a distance from the substrate surface according to (a) in the range from 0.5 to 10 mm, preferably in the range from 0.5 to 5 mm, more preferred in the range from 2 to 4 mm, more preferred in the range from 2.5 to 3.5 mm.

56. The plasma-assisted deposition method for applying a coating onto a surface of a substrate according to any one of embodiments 49 to 55, wherein the carrier gas is provided to the excitation zone with a flow in the range from 50 to 500 l/min, preferably in the range from 150 to 450 l/min, more preferred in the range from 200 to 300 l/min.

57. The plasma-assisted deposition method for applying a coating onto a surface of a substrate according to any one of embodiments 49 to 56, wherein alternating voltages up to 100 kV are applied, wherein the alternating voltage is preferably in the range of 10 to 40 kV.

58. The plasma-assisted deposition method for applying a coating onto a surface of a substrate according to any one of embodiments 49 to 57, wherein the discharge frequency is in the range from 50 to 100 kHz, preferably in the range from 60 to 100 kHz, more preferred in the range from 70 to 95 kHz, more preferred in the range from 80 to 90 kHz.

59. The plasma-assisted deposition method for applying a coating onto a surface of a substrate according to any one of embodiments 49 to 58, wherein the plasma-assisted deposition method is carried out at a temperature in the range of from 10 to 80 °C.

60. The plasma-assisted deposition method for applying a coating onto a surface of a substrate according to any one of embodiments 49 to 59, wherein the plasma-assisted deposition method is carried out for a total time in the range of from 30 seconds to 10 minutes, preferably in the range of from 1 to 2 minutes.

61. A plasma-assisted deposition method for applying a coating onto a surface of a substrate, wherein the plasma is generated at a pressure of <0.1 mbar, preferably in the range from 0.0001 to 0.09 mbar, preferably in the range from 0.001 to 0.05 mbar (low pressure plasma).

62. The plasma-assisted deposition method for applying a coating onto a surface of a substrate according to embodiment 61, wherein the plasma-assisted deposition method comprises

(a) providing a substrate having a surface;
(b’) generating an aerosol comprising a fluorine-free compound as defined in any one of embodiments 1 to 11 by using an atomizer gas;
(c’) transforming the precursor aerosol generated in (b’) into a plasma state by a combination of excitations comprising a main excitation by means of microwave-type electromagnetic waves, and a secondary excitation by means of an electric discharge of alternating voltage having a frequency between 1 kHz and 15 MHz, thereby generating a plasma;
(d’) treating at least a part of the substrate surface provided according to (a) with the plasma generated according to (c’), thereby depositing a reaction product of the fluorine-free compound on the treated part of the substrate surface thereby obtaining a coated substrate.

63. The plasma-assisted deposition method for applying a coating onto a surface of a substrate according to embodiment 62, wherein step (c) of the plasma-assisted deposition method comprises

(c’.a) providing the fluorine-free compound in liquid form, optionally with application of heating, in a vessel having an outlet;
(c’.b) passing an atomizer gas through a nozzle so that the atomizer gas gets in contact with the fluorine-free compound at the outlet of the vessel, thereby generating an aerosol comprising the fluorine-free compound.

64. A plasma-assisted deposition method for applying a coating onto a surface of a substrate, wherein the plasma-assisted deposition method comprises

(a) providing a substrate having a surface;
(b") providing an atmosphere comprising a fluorine-free compound as defined in any one of embodiments 1 to 11 in gaseous form or aerosol form, optionally under application of heating;
(c") generating a plasma from the atmosphere comprising the fluorine-free compound according to (b") under plasma-generating conditions by combination of excitations comprising a main excitation by means of microwave-type electromagnetic waves, and a secondary excitation by means of an electric discharge of alternating voltage having a frequency between 1 kHz and 15 MHz, thereby generating a plasma;
(d") treating at least a part of the substrate surface provided according to (a) with the plasma generated according to (c"), thereby depositing a reaction product of the fluorine-free compound on the treated part of the substrate surface thereby obtaining a coated substrate.

65. The plasma-assisted deposition method for applying a coating onto a surface of a substrate of any one of embodiments 49 or 50 or 61 to 64, wherein the fluorine-free compound is preferably selected from the group consisting of a lactam with 4 to 8 ring atoms, a lactone with 4 to 8, preferably 6 to 8, ring atoms, vinylacetate, polyvinylpyrrolidone, and mixtures of two or more of these compounds, more preferably from the group consisting of lactam with 4 to 8 ring atoms excluding caprolactam, a lactone with 4 to 8, preferably 6 to 8 ring atoms, vinylacetate, polyvinylpyrrolidone, and mixtures of two or more of these compounds, more preferably from the group consisting of lactam with 4 to 8 ring atoms excluding caprolactam and excluding vinylpyrrolidone, a lactone with 4 to 8, preferably 6 to 8, ring atoms, vinylacetate, polyvinylpyrrolidone, and mixtures of two or more of these compounds, more preferably from the group consisting of a lactone with 4 to 8, preferably 6 to 8, ring atoms, vinylacetate, polyvinylpyrrolidone, and mixtures of two or more of these compounds, more preferably from the group consisting of a lactone with 4 to 8 ring atoms, vinylacetate, and mixtures of two or more of these compounds, more preferably the fluorine-free compound is a lactone with 4 to 8, preferably 6 to 8, ring atoms.

66. The plasma-assisted deposition method for applying a coating onto a surface of a substrate of any one of embodiments 61 to 65, wherein the power density of electromagnetic waves is in the range of from 0.01 to 1 $W/cm^3$ and/or the power of the electric discharge is in the range of from 4 to 30 W and the frequency is in the range of from 20 to 200 kHz.

67. The plasma-assisted deposition method for applying a coating onto a surface of a substrate of any one of embodiments 49 to 66, wherein in the plasma-assisted deposition method, preferably in none of steps (a), (b), (c), (d), more preferably at least not in step (d), water is added and/or wherein the plasma-assisted deposition method, preferably at least step (d) thereof, is carried out in an atmosphere containing at the outmost as much water as contained in the atmosphere based on a relative humidity (RH) of 100 % at the respective process temperature.

68. The plasma-assisted deposition method for applying a coating onto a surface of a substrate of any one of embodiments 49 to 67, wherein the substrate comprises an organic polymer selected from the group consisting of polyolefin, preferably polyethylene (PE) or polypropylene (PP); polyamide (PA); polyurethane (PU); fluorinated polymer; silicone; polycarbonate (PC); polymethylmethacrylate (PMMA); polyacrylate; polyesters, especially polyethylene terephthalate (PET); cellulose; cellulose-derived polymers like cellulose acetate, lignin, lignin-based composites including wood; and mixtures of two or more of these organic polymers.

69. The plasma-assisted deposition method for applying a coating onto a surface of a substrate of any one of embodiments 49 to 68, wherein the substrate comprises an organic polymer selected from the group consisting of polyolefin, polyamide, polyester, and mixtures of two or more thereof, more preferred the substrate comprises an organic polymer selected from the group consisting of polyethylene, polyamide and mixtures of polyethylene and polyamide, more preferred the substrate comprises at least polyethylene (PE), more preferred high-density polyethylene (HDPE).

70. Use of a coated substrate according to any one of embodiments 1 to 48 or of a coated substrate obtained or obtainable from the plasma-assisted deposition method of any one of embodiments 49 to 69, for packaging, storing and/or transporting a good selected from the group consisting of food, beverage and chemical wherein the good is preferably a chemical, wherein the chemical is preferably a hazardous substance (transported as dangerous good) or an agrochemical, more preferably an agrochemical.

The present invention is further illustrated by the following reference examples, and examples.

**Examples**

**Reference Example 1: Plasma coating method**

Cast high-density polyethylene (HDPE) plates (cleaned by rinsing with isopropanol and blow-drying in air) with a size of 20 cm × 25 cm were pretreated in a PlasmaLine200® reactor (product of VITO) in a first coating step with a plasma generated using argon carrier gas at a flow of 250 slm, into which pure acetylene gas was fed at a flow of 2 × 2.5 slm (i.e. a feed of 2.5 slm per atomizer since the PlasmaLine200® reactor comprises two gas inlets linked to two atomizers). This gaseous mixture was fed into the afterglow region of the plasma, through which the HDPE plate was moved at a speed of 2 m/min for 30 times (hereinafter referred to as number of passes) and was thus coated with reaction products of acetylene. During this first coating step, the frequency of the DC current driving the plasma was set to 85 kHz, using a power of 150 W. The distance between the outlet of the excitation zone to the substrate surface was kept constant at 3 mm. The resulting HDPE plate had a coating with reaction products of acetylene on its surface and was called a "pretreated substrate". In a second coating step, a reaction product of epsilon-caprolactam was deposited on the pretreated substrate obtained from the first coating step. For this purpose, the pretreated substrate was exposed to another plasma generated using argon carrier gas at a flow of 250 slm, into which a epsilon-caprolactam was fed in the form of an aerosol obtained by vaporizing a 1000 g/L solution of the precursor in methanol with Ar gas in two atomizers at a flow of 1.5 slm per atomizer. The pretreated substrate was passed through the afterglow region for 30 times at a speed of 2 m/min and was thus coated with reaction products of the fluorine-free compound. During this second coating step, the frequency of the DC current driving the plasma was set to 85 kHz, using a power of 150 W. Based on the known surface area of the used high-voltage electrodes (100 $cm^2$), the power density applied in this coating process was 15 $kW/m^2$ or 1.5 $W/cm^2$. The distance between the outlet of the excitation zone to the substrate surface was kept constant at 3 mm. A substrate having deposited on its surface reaction products of acetylene and thereon reaction products of epsilon-caprolactam was thus obtained.

**Reference Example 2: Static contact angle measurements**

The wetting behavior of coated substrates and untreated references (e.g. blank HDPE) was studied by means of regular contact angle measurements, using three standard solvents (water as highly polar liquid, diiodomethane as highly non-polar liquid, and formamide as liquid of intermediate polarity). 8-10 droplets (volume: 0.5-2 μl) of these liquids

were deposited on the substrates and the contact angle was measured after 10 s by shape analysis (sessile drop method, fitting the drop contour by means of ellipsoids or circles) using a Krüss DSA100 instrument at ambient conditions (23°C). The resulting contact angles were averaged and are quoted as mean values with corresponding standard deviation. In addition, the contact angles obtained for water, formamide and diiodomethane were used to calculate the surface energy (with polar and dispersive components) of the substrate based on the theory of Owens and Wendt (D. Owens & R. Wendt, J. Appl. Polym. Sci. 1969, vol. 13, pp. 1741).

**Reference Example 3: X-ray photoelectron spectroscopy (XPS) analyses**

XPS analyses were carried out with a Kratos Axis Nova XPS-Spectrometer using monochromatic Al Kα radiation (120 W) with a spot size of 800 μm × 300 μm in standard configuration. The XPS system was calibrated according to ISO 15472.2001. The binding energy of Au 4f7/2 is 84.00 eV and that of Cu2p3/2 is 932.62 eV. All samples were mounted insulated against ground and neutralized during the measurements with a built-in charge neutralizer. Survey scan analyses were carried out with a pass energy of 160 eV and an energy step size of 0.5 eV. High-resolution analyses were carried out on the same analysis area with a pass energy of 40 eV and an energy step size of 0.1 eV. Spectra were charge-corrected to the main line of the carbon 1s spectrum set to 284.8 eV as a typical value quoted for the energy of the peak of adventitious hydrocarbon. All spectra were analyzed using standard XPS analysis software like CasaXPS (version 2.3.20) and applying Shirley background subtraction of the main peaks for the elements of interest (F1s, N1s, O1s, C 1s, Si 2p). Relative sensitivity factors and transmission function as provided by the instrument manufacturer were used for quantification.

Based on the type of substrate and precursor used, the surface coverage was calculated in three different ways from the collected XPS spectra:

(i) In cases where the substrate contained elements in significant concentrations that were not present in the precursor, surface coverage after plasma-assisted coating could be estimated by the following formula:

$$\text{Coverage (in percent)} = 100^*(1 - C_{sample}/C_{ref}) \qquad \text{Equation (XPS I)}$$

where $C_{sample}$ is the atomic concentration of the element specific to the substrate in at-% after the plasma treatment and $C_{ref}$ is the atomic concentration of the element specific to the substrate in at-% on the untreated clean reference. Hence a sample with the same concentration of the specific substrate element would result in zero percent coverage, while a sample with no detectable specific substrate element would result in 100 % coverage.

(ii) In cases where the precursor contained elements in significant concentrations that were not present on the substrate, surface coverage could be estimated based on the theoretical composition of the precursor used in the process, if there was conclusive experimental evidence that the precursor was deposited in this defined molecular form. Here, surface coverage after plasma-assisted coating could be calculated as:

$$\text{Coverage (in percent)} = 100^*(C_{sample}/C_{theor}) \qquad \text{Equation (XPS II)}$$

where $C_{sample}$ is the atomic concentration of the element specific to the coating in at-% after the plasma treatment and $C_{theor}$ is the atomic concentration of the element specific to the precursor in at-% calculated based on the stoichiometry of the precursor. Hence a sample with the same concentration of the element as in the theoretical composition would result in 100 % coverage, while a sample with no detectable specific precursor element would result in zero percent coverage.

(iii) In cases where the substrate contained elements that were also present in the precursor but existed in a different binding state and hence exhibited a different chemical shift in the XPS spectra, the coverage could be derived by using the relative fractions of the concerned elements in the binding states specific to the precursor as obtained from peak fitting procedures.

$$\text{Coverage (in percent)} = 100^*(C_{sample}/C_{theor.precursor}) \qquad \text{Equation (XPS III)}$$

For samples obtained by plasma-assisted coating of HDPE with reaction products of fluorine-free compounds, the surface coverages were calculated according to equation (XPS II) or equation (XPS III), while equation (XPS II) was used to calculate the coverage for the comparative sample obtained by plasma-assisted deposition of reaction products of tetramethylsilane (Comp2 in Table 2). Here and in the following, comparative samples are abbreviated as CompX,

wherein "X" is here a placeholder for the respective number of the comparative sample. For analyses according to equation (XPS III), the carbon 1s spectra of the coated substrates were fitted with components representing carbon atoms bound to either nitrogen or oxygen in the various possible forms as present on the substrate and, accordingly, in the precursor (e.g. COOR, amide, C-N, C-O for lactams, lactones and vinylacetate). The parameters used for this type of evaluation are shown in Table 1.

**Table 1**

| Parameters used for evaluation of XPS spectra and calculation of surface coverages in the case of lactams, lactones and vinylacetate precursors (Samples 2-9). | | | |
|---|---|---|---|
| Chemical group | Chemical shift in XPS spectra [eV] | Reference Peak | FWHM |
| CH2 | 284.8 eV | --- | 1.3-1.6 |
| Secondary C to O or N | 0.5 ± 0.2 eV | CH2 | 1.3-1.6 |
| C-N | 1.1 ± 0.2 | CH2 | 1.3-1.6 |
| C-O-R | 1.5 ± 0.2 | CH2 | 1.3-1.6 |
| C-O in C(=O)O-R | 4.1 ± 0.2 | CH2 | 1.3-1.6 |
| C-N in C(=O)-N-R | 3.0 ± 0.2 | CH2 | 1.3-1.6 |
| Acetal/Carbonyl | 2.7 ± 0.2 | CH2 | 1.3-1.6 |

For the estimation of surface coverages of comparative samples carrying fluorine-rich surface coatings (Comp3 and Comp4), the carbon 1s spectra of the coated substrates were fitted with components representing carbon atoms bound to fluorine in different stoichiometries (i.e. $CF_3$, $CF_2$, CHF) and fluorine-free functional groups (like $CH_2$) as present in the HDPE substrate. The parameters used for this type of evaluation are shown in Table 2.

**Table 2**

| Parameters used for evaluation of XPS spectra and calculation of surface coverages for fluorinated HDPE surfaces (Comp3, Comp4). | | | |
|---|---|---|---|
| Chemical group | Chemical shift in XPS spectra [eV] | Reference Peak | FWHM |
| CF3 | 2.3 ± 0.2 | CF2 | (CF2*0.75) ± 0.1 |
| CF2 | 290.8 ± 2.0 | - | 1.1-1.6 |
| CHF | -2.3 ± 0.2 | CF2 | (CF2*1) ± 0.1 |
| CH2 next to CHF | -4.6 ± 0.2 | CF2 | (CF2*1) ± 0.1 |
| CH2 | 284.8 | - | 1.3-1.8 |

The coverage was then calculated via the following equation:

$$coverage\ (\%) = C_F + C_C \sum_{i=1}^{3} \frac{R_{CFi}}{100} \quad \text{Equation (XPS IV)}$$

where $R_{CFi}$ is the percentage of the binding state of interest in the detail spectrum of the carbon 1s signal for carbon atoms bound to 1, 2, or 3 fluorine atoms, respectively, and $C_F$ and $C_C$ represent the total concentration (in atom-%) of fluorine and carbon, respectively, on the surface as derived from the survey spectrum.

In the case of alkynes such as 1-octyne, no determination via XPS was possible due to the lack of chemical difference compared to the HDPE substrate. Here, the presence of reaction products of the precursor on the substrate after plasma-assisted deposition could be independently verified by TEM imaging (as described in Reference Example 6) as well as atomic force microscopy (as described in Reference Example 7).

Finally, the surface coverage of the comparative samples consisting of coextruded HDPE and polyamide (Comp5), i.e. the amount of PA at the surface, could not be determined reliably by XPS due to the presence of strongly adhering surface contaminations.

**Reference Example 4: Time-of-flight secondary ion mass spectrometry (ToF-SIMS) analyses**

Static ToF-SIMS spectra were recorded using a ToF.SIMS 5 spectrometer (lonTOF GmbH, Münster Germany). A pulsed mass-filtered primary ion beam of 50 keV singly charged triple bismuth clusters ($Bi_3^{2+}$) was used to record spectra of secondary electrons over an area of 500 μm × 500 μm in positive ion detection mode. To prevent charging of the sample surface, a low-electron energy flood gun (-20 eV) was used. Mass resolution was limited by the roughness of the surfaces to a range of M/ΔM~1000 at 55 u and was improved by the use of the "Advanced ToF-Correction" as provided by SurfaceLab 7.2 after mass calibration by using the hydrocarbon peaks $CH_3^+$ (15 u), $C_2H_3^+$ (27 u), $C_3H_5^+$ (41 u), $C_3H_7^+$ (43 u) and $C_4H_7^+$ (55 u). The resulting spectra were compared to reference spectra of polymers synthesized by polycondensation.

**Reference Example 5: Inverse gas chromatography (iGC)**

The barrier effect of coated substrates and untreated references (e.g. blank HDPE) against organic solvents was assessed by means of inverse gas chromatography (iGC) (see Chapter "Surface Properties Characterization by Inverse Gas Chromatography (IGC) Applications", by Eric Brendlé, Eugene Papirer Book "Powders and Fibers", 1st Edition, 2006, ImprintCRC Press, page 76), using toluene vapor as test permeant. For this purpose, the substrates were cut into stripes of 14 cm in length and 1 cm in width and mounted into a sample cell as shown in Figure 1. The cell consisted of two 14 cm × 14 cm aluminium plates. On the bottom surface of the upper plate, a linear notch of 12.8 cm in length, 1 mm in width and 0.25 mm in depth was imprinted as chromatographic path (see Figure 1a). At both ends of the notch, 1/16" bores were drilled to allow for gas inlet and outlet. The sample stripe was placed along the notch (as shown in Figure 1b) and sandwiched between the upper and lower plates, which were then connected firmly by several screws to ensure gas tightness (see Figure 1c). Suitable Swagelok connectors and PEEK fittings were used to link the outer ends of the inlet and outlet bores on the top of the upper plate with PEEK capillaries (1/16", 10 cm long), through which the entire assembly was connected to the chromatograph. iGC experiments were performed on a Thermo Fisher Trace1310 gas chromatograph equipped with flame-ionization detectors (FIDs) and a PAL3 RSI injection system. The system was operated with Neuronics 2.2.3 und InPulse 2.3.5 software provided by Adscientis SARL. After assembly of the sample cell and connection to the GC instrument, the cell was placed in the oven of the GC and conditioned at 40 °C for 4 hours in dry helium (Nippon Gases, 6.0 quality) at a flow rate of 18 ml/min, in order to remove any volatile contaminants from the surface of the coated substrate.

Subsequently, liquid toluene (Honeywell, p.a. quality) was injected at a constant rate of 0.02 μl/s for a period of ca. 9 minutes into the He carrier gas at a corrected carrier gas flow rate of 5.4 ml/min and a temperature of 40 °C. In this way, the surface of the coated substrate (or the uncoated references) in the chromatographic channel of the cell was exposed to constant relative toluene pressure of $p/p_0 = 0.64$ (where $p_0$ is the saturation pressure of toluene at 40 °C). After initial adsorption of toluene on the sample surface, a stable FID reading was established in the course of the injection period in all cases, indicating that the surfaces were saturated with toluene under the given experimental conditions. Subsequently, injection was stopped and the substrates were purged with pure He carrier gas, leading to progressive desorption of toluene. Acquisition was stopped once a FID signal of 10 pA (corresponding to a relative toluene pressure of $p/p_0 = 4.5 \cdot 10^{-5}$) was reached and the respective time ($t_{R,end}$, referred to the point in time when toluene injection was stopped and puring with pure He was started) was noted as a first parameter characterizing the barrier effect (with higher $t_{R,end}$ indicating weaker barrier and vice versa). From the resulting desorption profiles, adsorption isotherms were calculated in the form of $q_{ads} = f(p/p_0)$, where $q_{ads}$ is the adsorbed amount of toluene at any given $p/p_0$ during desorption, according to procedures described in the literature (see Chapter "Surface Properties Characterization by Inverse Gas Chromatography (IGC) Applications", by Eric Brendlé, Eugene Papirer Book "Powders and Fibers", 1st Edition, 2006, ImprintCRC Press, page 76). The obtained isotherms were then evaluated using the Brunauer-Emmett-Teller (BET) theory (see Brunauer, Stephen; Emmett, P. H.; Teller, Edward (1938). "Adsorption of Gases in Multimolecular Layers". Journal of the American Chemical Society. 60 (2): 309-319) for a relative pressure regime of $0.01 \leq p/p_0 \leq 0.05$, giving the monolayer binding capacity $q_{BET}$ as well as the corresponding BET constant $C_{BET}$ as additional two parameters to characterize the barrier effect (note that $q_{BET}$ describes the number of binding sites for toluene on the investigated surface and is expressed as molar amounts of adsorbed toluene molecules per unit of explored surface area in μmol/cm$^2$, whereas $C_{BET}$ indicates the strength of binding). Strong barrier against toluene vapor is reflected by low values for $q_{BET}$ and/or $C_{BET}$.

**Reference Example 6: Transmission electron microscopy (TEM) analyses**

The thin fluorine-free layers present on the HDPE surface after the successful plasma- assisted coating process were visualized in cross-section by TEM imaging. For sample preparation, the plasma-treated surface was first coated with a layer of platinum (thickness: about 50 nm) and then embedded in an epoxy resin. Ultrathin cross-sections were

prepared via cryo-ultramicrotomy using a Leica UC 7 microtome. The resulting thin sections of the samples were examined on a Zeiss Libra 120 microscope equipped with an omega filter and operating at an acceleration voltage of 120 kV in elastic and inelastic mode.

**Reference Example 7: Determination of surface roughness by atomic force microscopy (AFM)**

The surface roughness of coated substrates and uncoated references was characterized by means of AFM using a Dimension ICON instrument from Bruker under ambient conditions. Topographical height images were collected in tapping mode covering surface areas of 2 μm × 2 μm, 5 μm × 5 μm and 50 μm × 50 μm. From the 2 μm × 2 μm images, the roughness values Ra and Rq were derived. Ra roughness is defined as the arithmetic average of the absolute values of the surface height deviations (Z) measured from the respective mean plane at each analyzed point in the image (i) with a total number N of analyzed points:

$$R_a = \frac{1}{N}\sum_{i=1}^{N}|Z_i|$$

Rq represents the root mean square (RMS) surface roughness, calculated according to:

$$R_q = \sqrt{\frac{1}{N}\sum_{i=1}^{N} Z_i^2}$$

**Example 1: Plasma treatment of HDPE plates**

Prior to plasma-assisted coating, all HDPE substrates were cleaned by rinsing with isopropanol and subsequent blow-drying. For each selected chemical precursor and set of process parameters, at least two HDPE plates were coated independently by plasma-enhanced chemical vapor deposition according to Reference Example 1. Precursors were supplied either in pure liquid state or as solution in organic solvents. The chosen precursors with their respective coating conditions are summarized in Table 2. The following process parameters were the same for all samples listed in Table 2:

| | |
|---|---|
| - Type of carrier gas: | Argon |
| - Carrier gas flow rate: | 250 l/min |
| - Type of atomizer gas: | Argon |
| - Frequency of DC current: | 85 kHz |
| - Distance from outlet of excitation zone to substrate: | 3 mm |
| - Speed of substrate motion through afterglow region: | 2 m/min |
| - Substrate: | HDPE |

In all cases, the HDPE plates were pretreated by plasma coating with acetylene as described in Reference Example 1.

For comparison, HDPE substrates were analyzed without coating (Comp1) and after coating by plasma-enhanced chemical vapor deposition using tetramethylsilane (Comp2) as precursor compound, following the same process as in Reference Example 1.

For further comparison, commercially available HDPE containers were purchased and analyzed in full analogy to the samples prepared by plasma-assisted deposition as described above. The following types of containers (all 5 l canisters, manufactured according to state-of-the-art processes established in the packaging industry and characterized on their respective interior surface) were included in the analyses: (i) HDPE coated by plasma treatment with the fluorine-containing precursor Freon R-134a (referred to as "Plasma-F", Comp3, having a fluorine-rich layer of 50-60 nm in thickness on its interior surface, as determined by TEM analyses on cross-sections), (ii) HDPE coated with $F_2$ gas (referred to as "Direct-F", Comp4, having a fluorine-rich layer of ca. 200 nm in thickness on its interior surface, as determined by TEM analyses on cross-sections), and (iii) HDPE coextruded with polyamide-6 (referred to as "PE/PA Coex", Comp5, having a polyamide-rich layer of 50-60 μm in thickness on its interior surface, as determined by AFM

analyses on cross-sections), (ii)

**Table 3**

| Plasma process conditions used for the preparation of fluorine-free coatings on HDPE according to the present invention (Samples 1-9), with uncoated HDPE (Comp1) and coatings based on silane (Comp2) as comparative samples (n/a: not applicable). | | | | | | |
|---|---|---|---|---|---|---|
| **Sample No.** | **Precursor** | **Precursor state** | **Power density [kW/m$^2$]** | **Atomizer flow [slm]** | **Number of passes** | **Co-reactant** |
| Comp1 | None | n/a | n/a | n/a | n/a | None |
| Comp2 | tetramethylsilane (TMS) | Pure liquid | 15 | 2 × 2.0 | 15 | None |
| 1 | 1-octyne | Pure liquid | 20 | 2 × 1.5 | 30 | None |
| 2 | delta-valerolactam | 400 g/l solution in methanol | 20 | 2 × 1.5 | 30 | None |
| 3 | epsilon-caprolactam | 1000 g/l solution in methanol | 15 | 2 × 1.5 | 30 | None |
| 4 | gamma-butyrolactone | Pure liquid | 15 | 2 × 2.0 | 30 | None |
| 5 | delta-valerolactone | Pure liquid | 15 | 2 × 1.5 | 30 | None |
| 6 | 2-pyrrolidone | 400 g/l solution in methanol | 15 | 2 × 1.5 | 30 | None |
| 7 | Polyvinylpyrrolidone (molecular weight: 10 kDa) | 500 g/l solution in methanol | 15 | 2 × 1.5 | 30 | None |
| 8 | vinylacetate | Pure liquid | 20 | 2 × 1.5 | 30 | None |
| 9 | vinylacetate | | 20 | 2 × 1.5 | 20 | $C_2H_2$ 2 × 2.5 slm |

**Example 2: Surface coverage of HDPE substrates after plasma-assisted coating**

The samples prepared as described in Example 1 were analysed with respect to their surface coverage by XPS according to Reference Example 3. The results are listed in Table 4. Surface coverages could not be determined by XPS for Sample 1 and Comp5, as explained in Reference Example 3.

**Table 4**

| Surface coverages (average values) determined by means of XPS analysis according to Reference Example 3 for HDPE substrates before and after plasma-assisted coating (n.d.: value not determined; n/a: not applicable). | |
|---|---|
| **Sample No.** | **Surface coverage in %** |
| Comp1 | n/a |
| Comp2 | 15.4 |
| Comp3 | 72.4 |
| Comp4 | 76.8 |
| Comp5 | n.d. |
| 1 | n.d. |
| 2 | 22.2 |
| 3 | 79.5 |

(continued)

| Surface coverages (average values) determined by means of XPS analysis according to Reference Example 3 for HDPE substrates before and after plasma-assisted coating (n.d.: value not determined; n/a: not applicable). | |
|---|---|
| **Sample No.** | **Surface coverage in %** |
| 4 | 31.5 |
| 5 | 45.7 |
| 6 | 76.4 |
| 7 | 91.2 |
| 8 | 27.5 |
| 9 | 11.4 |

The data showed that nominal surface coverages of samples prepared according to the present invention varied over a broad range (11-92 %) as depending on the type of used precursor, even though the chosen process conditions for plasma-assisted deposition were similar. In turn, relatively high surface coverages (72-77 %) were obtained for fluorinated reference materials (i.e. Comp3, Comp4). Nevertheless, several of the inventive fluorine-free coatings could compete with these reference materials (and the PE/PA-COEX material, Comp5) in terms of barrier properties determined against toluene vapor, as described in Example 5, despite their low thickness. This indicated that a certain minimum coverage was required for strong barrier performance, but the particular threshold depended on the type of precursor used.

**Example 3: ToF-SIMS characterization of polyamide obtained from plasma-assisted coating as compared to conventional polyamide-6**

Coatings obtained via plasma-assisted deposition of epsilon-caprolactam (Sample 3, hereinafter referred to as "plasma-polyamide") as described in Example 1 were analyzed in comparison to a bulk polyamide-6 sample, wherein the PA-6 was made by classical condensation polymerization (Comp5). Analysis was done by ToF-SIMS according to Reference Example 4. The results are shown in Table 5, while the corresponding ToF-SIMS spectra (cation detection mode) in the range of 5-300 amu are shown in Fig. 2.

**Table 5**

| Nominal masses of selected peaks detected by ToF-SIMS for plasma-polyamide in comparison to conventional polyamide-6. | |
|---|---|
| **Plasma-Polyamide (Sample 3)** | **Polyamide-6 (Comp5)** |
| 30 (H2N+=CH2) | 30 (H2N+=CH2) |
| 56 (H2N+=CH-CH=CH2) | 56 (H2N+=CH-CH=CH2) |
| 112 (M-H)+ | 114 (M+H+) |
| 207 (2M-H-H2O)+ | 209 (2M+H-H2O) + |
| 225 (2M-2H)+ | 227 (2M+H)+ |
| 318 (3M-3H-H2O)+ | 322 (3M+H-H2O)+ |
| 336 (3M-3H)+ | 340 (3M+H)+ |
| 449 (4M-4H)+ | 453 (4M+H)+ |

The data in Table 5 showed that for polyamide-6 produced by conventional polycondensation, a monomer+$H^+$ ion was detected at 114 amu, whereas for coatings obtained from plasma-assisted deposition of reaction products of epsiloncaprolactam, fragments appeared at a nominal mass of 112. This indicated the formation of a polyamide material by hydrogen abstraction and subsequent radical polymerization. The same pattern was found for all other characteristic fragments and deviations between plasma-polyamide and conventional PA-6 become more pronounced with higher masses, due to the difference of one nominal mass unit per monomer in the two types of polymer.

**Example 4: Wetting behavior of HDPE substrates after plasma-assisted coating**

The effect of the coating of HDPE substrates with reaction products of different precursors via plasma-assisted deposition (prepared as described in Example 1) on the wetting behavior was assessed by static contact angle measurements using water, formamide and diiodomethane as test liquids. For comparison, several commercially available HDPE containers with different barrier technologies (Comp3, Comp4, Comp5) as well as uncoated HDPE material (Comp1) were also analyzed.

The results are shown as bar plots in Fig. 3 and listed as average values (AVG) with corresponding standard deviation (SdDev) in Table 6.

**Table 6**

| Static contact angles (average values with corresponding standard deviations) determined according to Reference Example 2 for water, formamide and diiodomethane on HDPE after plasma-assisted deposition of different precursors according to the present invention (Samples) and selected comparative samples (CompX). | | | | | | |
|---|---|---|---|---|---|---|
| | Contact angle [°] | | | | | |
| | Water | | Diiodomethane | | Formamide | |
| Sample No. | AVG | SdDev | AVG | SdDev | AVG | SdDev |
| Comp1 | 97.1 | 1.7 | 45.7 | 1.3 | 76.2 | 1.7 |
| Comp2 | 108.4 | 1.3 | 72.0 | 1.7 | 95.7 | 2.0 |
| Comp3 | 102.0 | 4.0 | 50.6 | 4.1 | 70.6 | 1.1 |
| Comp4 | 90.0 | 2.4 | 68.2 | 2.5 | 43.1 | 4.0 |
| Comp5 | 85.5 | 1.6 | 59.8 | 1.2 | 76.0 | 0.9 |
| 1 | 112.0 | 3.5 | 47.3 | 0.8 | 76.3 | 1.7 |
| 2 | 26.7 | 0.8 | 37.6 | 1.6 | 11.9 | 1.6 |
| 3 | 14.4 | 1.3 | 37.0 | 0.8 | 11.3 | 0.5 |
| 4 | 11.2 | 0.7 | 15.7 | 0.9 | 8.3 | 1.6 |
| 5 | 45.3 | 1.1 | 37.8 | 0.2 | 10.0 | 2.0 |
| 6 | 10.3 | 1.5 | 33.6 | 0.5 | 14.7 | 0.9 |
| 7 | 39.8 | 1.3 | 33.1 | 1.0 | 9.5 | 1.8 |
| 8 | 28.8 | 0.3 | 38.2 | 0.5 | 8.4 | 0.9 |
| 9 | 62.9 | 2.0 | 38.7 | 1.9 | 43.7 | 1.5 |

It was observed that plasma-assisted deposition of reaction products of fluorine-free polar compounds on HDPE substrates according to the present invention (Samples 2-9) resulted in increased wettability (lower contact angles after coating) against all three test liquids used. Static contact angles measured against water were in the range of 10 to 65 °, as compared to 97.1° for uncoated HDPE and 85-110° for Comp2 - Comp5. This indicated that coating with polar (i.e. more hydrophilic) fluorine-free precursors was successful. Similar trends of enhanced wettability were also observed for the unpolar test liquid diiodomethane (15-40° for Samples 2-9 as compared to >45°for all Comparative Samples) and medium-polar formamide (8-15°for Samples 2-8 and 43.7°for Sample 9 due to the non-polar co-reactant, compared to 70-80°for Comp1, Comp 2, Comp 3 and Comp 5, with Comp4 as exception). The only differing inventive example was Sample 1, i.e. coatings obtained by plasma-assisted deposition of reaction products of 1-octyne. However, this was reasonable as alkynes are non-polar compounds in contrast to lactams, lactones and vinylacetate. In fact, the wetting behavior observed for Sample 1 was rather similar to uncoated HDPE, which is expected in view of the chemical similarity of polyethylene and reaction products of 1-octyne.

Based on the static contact angles measured for water, formamide and diiodomethane, the surface free energy as well as its polar and dispersive components were calculated for uncoated and coated HDPE according to Reference Example 2, giving the values listed in Table 7 and displayed as bar plot in Fig. 3.

**Table 7**

| Surface free energy, with disperse and polar components, as determined according to Reference Example 2 from the static contact angles measured for water, formamide and diiodomethane on HDPE after plasma-assisted deposition of different precursors according to the present invention (Samples) and selected comparative samples ComX. | | | |
|---|---|---|---|
| | Surface energy [mN $m^{-1}$] | | |
| Sample No. | dispersive | polar | total |
| Comp1 | 33.7 | 0.3 | 34.0 |
| Comp2 | 19.2 | 0.2 | 19.4 |
| Comp3 | 34.7 | 0.1 | 34.8 |
| Comp4 | 30.8 | 3.3 | 34.1 |
| Comp5 | 25.0 | 4.1 | 29.1 |
| 1 | 36.9 | 0.5 | 37.4 |
| 2 | 36.3 | 30.4 | 66.7 |
| 3 | 35.4 | 34.8 | 70.2 |
| 4 | 41.2 | 31.3 | 72.5 |
| 5 | 39.3 | 20.5 | 59.8 |
| 6 | 36.1 | 34.8 | 70.9 |
| 7 | 40.1 | 22.6 | 62.7 |
| 8 | 36.6 | 29.6 | 66.2 |
| 9 | 37.4 | 10.9 | 48.3 |

In line with the individual static contact angles, the calculated surface free energies showed that plasma-assisted deposition of reaction products of fluorine-free polar compounds on HDPE substrates resulted in a substantial increase in surface energy (48-73 mN/m for Samples 2-9, as compared to <35 mN/m for Comp1 - Comp 5), which was mainly caused by an increased polar component of surface energy (10-35 mN/m for Samples 2-9, as compared to <5 mN for Comp1 - Comp5). Again, coatings formed from reaction products of 1-octyne (Sample 1) were a reasonable exception, with surface energy profiles being very similar to uncoated HDPE (Comp1). Notably, the surface energy of a coextrudate of HDPE and polyamide (Comp5) was significantly lower (in terms of both dispersive and polar contributions) than the surface energy of a HDPE substrate coated with reaction products of epsilon-caprolactam in a plasma-assisted process according to the present invention (Sample 3), despite the expected chemical similarity. This indicated that plasma-polymerized caprolactam was different from conventional polyamide obtained by polycondensation of caprolactam, as also suggested by ToF-SIMS analyses (as described in Example 3) and analyses of surface roughness (as described in Example 7).

**Example 5: Barrier properties of HDPE substrates after plasma-assisted coating**

The effect of the coating of HDPE substrates with reaction products of different fluorine-free precursors via plasma-assisted deposition -i.e. the samples of Example 1- on the barrier properties against toluene vapor was assessed by inverse gas chromatography as described by Reference Example 5. For comparison, also an uncoated HDPE substrate (Comp1), HDPE coated with silane precursors by plasma-assisted deposition (Comp2) and commercial HDPE containers with different barrier technologies (Comp3, Comp4, Comp5) were also analyzed. Values obtained for the three physical parameters characterizing the barrier performance (as described in Reference Example 5) are listed in Table 8 for selected coatings according to the present invention (Samples) and the different comparative samples (CompX). Corresponding bar plots for the three parameters are shown in Fig. 5, 6 and 7.

**Table 8**

| Monolayer binding capacities ($q_{BET}$), BET constants ($C_{BET}$) and characteristic retention times ($t_{R,end}$) determined for the interaction of toluene vapor with uncoated and coated HDPE by means of inverse gas chromatography according to Reference Example 5. The relative pressure range used for evaluation of the adsorption isotherms according to the BET theory was $0.01 \leq p/p_0 \leq 0.05$ (n.d.: value not determined). | | | |
|---|---|---|---|
| Sample No. | $q_{BET}$ | $C_{BET}$ | $t_{R,end}$ |
| | [$\mu$mol/cm$^2$] | [no dimension] | [min] |
| Comp1 | 1.62 | 234 | 208 |
| Comp2 | 0.74 | 495 | 201 |
| Comp3 | 0.47 | 84 | 39 |
| Comp4 | 0.50 | 73 | 36 |
| Comp5 | 0.50 | 80 | 37 |
| 1 | 0.59 | 121 | 95 |
| 2 | 0.64 | 116 | 94 |
| 3 | 0.53 | 87 | 54 |
| 4 | 1.00 | 289 | 227 |
| 5 | 0.67 | 148 | 114 |
| 6 | 0.70 | 172 | 133 |
| 7 | n.d. | n.d. | n.d. |
| 8 | 0.51 | 74 | 40 |

The collected data showed that monolayer capacities for toluene binding were reduced - relative to untreated HDPE - by coatings with fluorine-free compounds according to the present invention to a similar extent (e.g. ($q_{BET}$ = 0.53 $\mu$mol/cm$^2$ for coatings based on epsilon-caprolactam, Sample 3) as well as for comparative coatings made from a fluorine-containing compounds such as Freon R-134a ($q_{BET}$ = 0.47 $\mu$mol/cm$^2$, Comp3) or $F_2$ gas ($q_{BET}$ = 0.50 $\mu$mol/cm$^2$, Comp4) as well as an HDPE packaging material with PA-based barrier technology ($q_{BET}$ = 0.50 $\mu$mol/cm$^2$, Comp5). Compared to an uncoated substrate (Comp1), which has a $q_{BET}$ value of 1.62 $\mu$mol/cm$^2$, the monolayer capacity was improved (i.e. further reduced) by the coating with fluorine-free compounds according to the invention by at least 20 %, preferably by at least 30 %. $C_{BET}$ values of the coatings made from fluorine-free compounds according to the invention were in the same range as $C_{BET}$ values of a comparative coating made from a fluorine-containing compound such as Freon R-134a or $F_2$ gas, which had $C_{BET}$ values in the range of from 70 to 90, and HDPE packaging material with PA-based barrier technology ($C_{BET}$ = 80). Again, these values were considerably lower than observed for uncoated HDPE (234) or TMS-treated substrates (495). Analogous trends and conclusions could also be inferred from the characteristic retention times, which were significantly shorter for coatings made from fluorine-free compounds according to the present invention (except for Sample 4 with gamma-butyrolactone as precursor) and fluorine-containing compounds and PA-based barriers, as compared to uncoated and TMS-treated HDPE.

**Example 6: Thickness of coatings obtained by plasma-assisted deposition on HDPE**

The thickness of the coatings formed on HDPE substrates with reaction products of different fluorine-free compounds via plasma-assisted deposition -i.e. selected samples of Example 1-was assessed by TEM analysis as described by Reference Example 6. Representative TEM images of cross-sections prepared from HDPE substrates coated with 1-octyne, epsilon-caprolactam, vinylacetate and delta-valerolactone are shown in Fig. 8. The images demonstrate that closed and dense layers of the reaction products of the fluorine-free compounds were formed with all selected precursors, yielding coatings with a thickness in the range of 20 to 500 nm, preferably in the range of from 50 to 350 nm, more preferably in the range of from 50 to 200 nm.

**Example 7: Roughness of coatings obtained by plasma-assisted deposition on HDPE**

The roughness of the coatings formed on HDPE substrates with reaction products of different fluorine-free

compounds via plasma-assisted deposition -i.e. selected samples of Example 1-was determined by AFM according to Reference Example 7. The resulting values for the arithmetic mean roughness (Ra) and the root mean square (RMS) roughness (Rq) are listed in Table 9, while the corresponding topographical images are shown in Fig. 9. For comparison, roughness values of selected comparative samples are also included in Table 9.

**Table 9**

Values for the arithmetic mean roughness (Ra) and the root mean square (RMS) roughness (Rq) determined for the surface of inventive and comparative samples by means of atomic force microscopy as described in Reference Example 7.

| Sample No. | Ra (nm) | Rq (nm) |
|---|---|---|
| Comp1 | 42.7 | 52.5 |
| Comp2 | n.d. | n.d. |
| Comp3 | 33.3 | 44.2 |
| Comp4 | 50.1 | 62.4 |
| Comp5 | 20.3 | 25.7 |
| 1 | 72.8 | 90.7 |
| 2 | n.d. | n.d. |
| 3 | 48.4 | 62.5 |
| 4 | n.d. | n.d. |
| 5 | 51.1 | 65.2 |
| 6 | n.d. | n.d. |
| 7 | n.d. | n.d. |
| 8 | 63.5 | 81.1 |
| 9 | n.d. | n.d. |

The AFM images in Fig. 9 showed that plasma-assisted deposition led to the formation of closed nanostructured coatings consisting of multiple particulate domains with individual sizes in a typical range of 50-150 nm. This structure resulted in Ra values ranging from 45 to 75 nm and Rq values ranging from 60 to 100 nm. Comparative samples showed slightly lower roughness, with Ra values ranging from 20 to 50 nm and Rq values ranging from 25 to 65 nm.

**Short description of the Figures**

Fig. 1: shows the experimental setup used for iGC measurements of barrier effects against toluene vapor.

(a) Bottom view of the upper plate of the sample cell, with bores for gas inlet and outlet on both ends of a linear notch serving as chromatographic path.
(b) Bottom view of the upper plate of the cell after mounting of a sample stripe.
(c) Top view of the assembled sample cell with PEEK capillaries mounted on the inlet and outlet bore for connection to the GC instrument.

Fig. 2: shows Tof-SIMS spectra of plasma-polyamide (Sample 3) and a conventional polyamide-6 reference (Comp5) (cation detection mode) in the range of 0-500 atomic mass units (amu).

Fig. 3 shows a bar plot comparing average values (with corresponding standard deviation) of static contact angles measured for water, formamide and diiodomethane according to Reference Example 2 on uncoated and coated HDPE (see Table 6 for individual values).

Fig. 4 shows a bar plot comparing values of surface free energy, with its polar and dispersive contributions, derived

according to Reference Example 2 from static contact angles of water, formamide and diiodomethane on uncoated and coated HDPE (see Table 7 for individual values).

Fig. 5 shows a bar plot comparing values of the monolayer capacity ($q_{BET}$) available for adsorption of toluene on uncoated and coated HDPE, as derived by inverse gas chromatography according to Reference Example 5. $q_{BET}$ values were obtained by evaluation across a relative pressure range of $0.01 \leq p/p_0 \leq 0.05$ (see Table 8 for individual values; n.d.: value not determined).

Fig. 6 shows a bar plot comparing values of the BET constant ($C_{BET}$), i.e. the affinity for adsorption of toluene on uncoated and coated HDPE for adsorption of toluene, derived by inverse gas chromatography according to Reference Example 5. $C_{BET}$ values were obtained by evaluation across a relative pressure range of $0.01 \leq p/p_0 \leq 0.05$ (see Table 8 for individual values; n.d.: value not determined).

Fig. 7 shows a bar plot comparing values of the characteristic retention time ($t_{R,end}$) determined by inverse gas chromatography for the interaction of toluene vapor with uncoated and coated HDPE according to Reference Example 5 (see Table 8 for individual values; n.d.: value not determined).

Fig. 8 shows TEM images of cross-sections prepared from HDPE substrates after plasma-assisted coating with reaction products of selected fluorine-free compounds: 1-octyne (Sample 1), epsilon-caprolactam (Sample 3), vinylacetate (Sample 8) and delta-valerolactone (Sample 2). The samples were coated with a layer of platinum (for contrast reasons) and embedded in a resin prior to cross-sectioning. The outer layer deposited by the plasma process is clearly visible in all cases and can be used to quantify the thickness of the coatings.

Fig. 9 shows AFM height images of the surface of HDPE substrates after plasma-assisted coating with reaction products of selected fluorine-free compounds: 1-octyne (Sample 1), epsilon-caprolactam (Sample 3), vinylacetate (Sample 8) and delta-valerolactone (Sample 2). For comparison, an image of the HDPE substrate prior to plasma-assisted deposition is also shown. From the topographical information contained in the images, Ra and Rq values (reported in Table 9) were derived as measure for the surface.

**Cited Literature**

- WO 2007/072120 A1
- US 2022/0112595 A1
- Chapter "Surface Properties Characterization by Inverse Gas Chromatography (IGC) Applications", by Eric Brendlé, Eugene Papirer Book "Powders and Fibers", 1st Edition, 2006, ImprintCRC Press, page 76
- Brunauer, Stephen; Emmett, P. H.; Teller, Edward (1938). "Adsorption of Gases in Multimolecular Layers". Journal of the American Chemical Society. 60 (2): 309-319
- WO 2006/081637 A1
- Vangeneugden et al, "Atmospheric DBD plasma processes for production of lightweight omposites" published at the 21st International Symposium on Plasma Chemistry (https://www.ispc-conference.org/ispcproc/ispc21/ID287.pdf


**Claims**

**1.** A coated substrate, wherein the coating is obtained or obtainable from depositing on a surface of a substrate by a plasma-assisted deposition method a reaction product of a fluorine-free compound selected from the group consisting of a lactam with 4 to 8 ring atoms, a lactone with 4 to 8 ring atoms, vinylacetate, polyvinylpyrrolidone, C5 to C8 alkyne and mixtures of two or more of these compounds.

**2.** The coated substrate of claim 1, wherein the lactam with 4 to 8 ring atoms has formula (I)

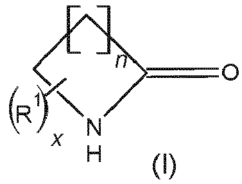

(I)

wherein

$R^1$ is a vinyl group,
x is zero or 1, and
n is an integer in the range of from 2 to 5, preferably in the range of from 2 to 4, more preferably n is 4 and x is zero (epsilon-caprolactam) and/ or n is 2 and x is 1, wherein $R^1$ is a vinyl group substituting the hydrogen atom at the nitrogen of the ring structure (vinylpyrrolidone).

3. The coated substrate of any one of claims 1 or 2, wherein the lactone with 4 to 8 ring atoms, preferably 6 to 8 ring atoms, has formula (II)

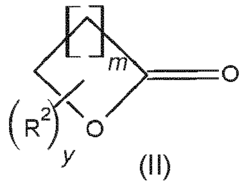

(II)

wherein

$R^2$ is selected from methyl group and vinyl group,
y is zero or 1, and
m is an integer in the range of from 1 to 5, preferably in the range of from 3 to 4,

wherein the lactone is more preferably selected from the group consisting of delta valerolacton, gamma valerolacton, epsilon caprolacton, and mixtures of two or more of these lactones, more preferably the lactone comprises at least, more preferably is, gamma valerolacton.

4. The coated substrate of any one of claims 1 to 3, wherein vinylacetate has formula (III)

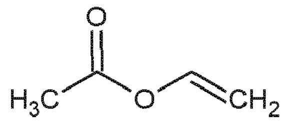

(III)

5. The coated substrate of any one of claims 1 to 4, wherein the polyvinylpyrrolidone has a weight average molecular weight of ≥ 222 g/mol, preferably in the range of from 2,500 to 2,500,000 g/mol, more preferably in the range of from 6,000 to 40,000 g/mol.

6. The coated substrate of any one of claims 1 to 5, wherein the C5 to C8 alkyne is a straight or branched C5 to C8 alkyne, preferably a straight chain C5 to C8 alkyne, which more preferably has formula (V)

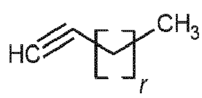

(V)

wherein r is an integer in the range of from 2 to 5, preferably r is 5.

**7.** The coated substrate of any one of claims 1 to 6, wherein at least 80 weight-%, preferably at least 90 weight-%, more preferably at least 95 weight-% of the compound used for depositing the coating are a compound of one of the groups according to claims 1 to 4, based on the total weight of all compounds used for depositing the coating, i.e. at least 80 weight-%, preferably at least 90 weight-%, more preferably at least 95 weight-% of the coating consists of a reaction product of a compound of one of the groups according to claims 1 to 6.

**8.** The coated substrate of any one of claims 1 to 7, wherein a further compound is used for depositing the coating on the surface of the substrate by a plasma-assisted deposition method, which is selected from the group consisting of C2 to C4 alkene, C2 to C4 alkyne and mixtures thereof, more preferably from the group consisting of C3 to C4 alkene, C2 to C4 alkyne and mixtures thereof, preferably the compound used for depositing the coating on the surface of the substrate by a plasma-assisted deposition method comprises at least vinylacetate and the further compound is acetylene, more preferably the compound used for depositing the coating on the surface of the substrate by a plasma-assisted deposition method is vinylacetate and the further compound is acetylene.

**9.** The coated substrate of claims 1 to 8, wherein in the range of from 50 to 90 weight-%, preferably in the range of from 80 to 90 weight-%, of the compound used for depositing the coating are a compound of one of the groups according to claims 1 to 6, based on the total weight of all compounds used for depositing the coating and in the range of from 10 to 50 weight-%, preferably in the range of from 10 to 20 weight-%, are a further compound according to claim 8.

**10.** The coated substrate of any one of claims 1 to 9 wherein the monolayer binding capacity ($q_{BET}$) is in the range of from 0.3 to 1.3 $\mu$mol/cm$^2$, preferably in the range of from 0.4 to 1.2 $\mu$mol/cm$^2$, more preferably in the range of from 0.5 to 1.1 $\mu$mol/cm$^2$, determined by Inverse Gas Chromatography (iGC) for toluene vapor according to Reference Example 5, and/or the BET constant ($C_{BET}$) is in the range of from 50 to 300, preferably in the range of from 50 to 200, more preferably in the range of from 70 to 175, determined by Inverse Gas Chromatography (iGC) for toluene vapor according to Reference Example 5.

**11.** The coated substrate of any one of claims 1 to 10, wherein a layer comprising a reaction product of acetylene is present between the substrate's surface and the coating comprising a reaction product of the fluorine-free compound, wherein the layer comprising a reaction product of acetylene is preferably obtained or obtainable from a plasma-assisted deposition of acetylene.

**12.** A plasma-assisted deposition method for applying a coating onto a surface of a substrate comprising:

(a) providing a substrate having a surface;
(b) generating a plasma under plasma-generating conditions by passing a carrier gas through an excitation zone and by applying high-frequency alternating current to an electrode positioned in the excitation zone to produce a dielectric barrier discharge thereby generating a plasma;
(c) generating an aerosol comprising a fluorine-free compound as defined in any one of claims 1 to 6 by using an atomizer gas;
(d) treating at least a part of the substrate surface provided according to (a) with the plasma generated according to (b) and the aerosol comprising the fluorine-free compound generated according to (c), thereby depositing a reaction product of the fluorine-free compound on the treated part of the substrate surface thereby obtaining a coated substrate,

wherein the plasma is preferably generated in (a) at a pressure in the range from 0.5 to 1.5 bar, preferably in the range from 0.8 to 1.2 bar (atmospheric or near-atmospheric conditions, indirect atmospheric pressure plasma processing).

**13.** A plasma-assisted deposition method for applying a coating onto a surface of a substrate comprising:

(a) providing a substrate having a surface;
(b') generating an aerosol comprising a fluorine-free compound as defined in any one of claims 1 to 6, preferably by using an atomizer gas;
(c') transforming the precursor aerosol generated in (b') into a plasma state by a combination of excitations comprising a main excitation by means of microwave-type electromagnetic waves, and a secondary excitation

by means of an electric discharge of alternating voltage having a frequency between 1 and 15 MHz, thereby generating a plasma;
(d') treating at least a part of the substrate surface provided according to (a) with the plasma generated according to (c'), thereby depositing a reaction product of the fluorine-free compound on the treated part of the substrate surface thereby obtaining a coated substrate;

wherein the plasma is generated at a pressure of <0.1 mbar, preferably in the range from 0.0001 to 0.09 mbar, preferably in the range from 0.001 to 0.05 mbar (low pressure plasma).

**14.** A plasma-assisted deposition method for applying a coating onto a surface of a substrate, wherein the plasma-assisted deposition method comprises

(a) providing a substrate having a surface;
(b") providing an atmosphere comprising a fluorine-free compound in gaseous form or aerosol form as defined in any one of claims 1 to 6, optionally under application of heating;
(c") generating a plasma from the atmosphere comprising the fluorine-free compound according to (b") under plasma-generating conditions by a combination of excitations comprising a main excitation by means of microwave-type electromagnetic waves, and a secondary excitation by means of an electric discharge of alternating voltage having a frequency between 1 and 15 MHz, thereby generating a plasma;
(d") treating at least a part of the substrate surface provided according to (a) with the plasma generated according to (c"), thereby depositing a reaction product of the fluorine-free compound on the treated part of the substrate surface thereby obtaining a coated substrate;

wherein the plasma is generated at a pressure of < 0.1 mbar, preferably in the range from 0.0001 to 0.09 mbar, preferably in the range from 0.001 to 0.05 mbar (low pressure plasma).

**15.** Use of a coated substrate according to any one of claims 1 to 11 or of a coated substrate obtained or obtainable from the plasma-assisted deposition method of any one of claims 12 to 14, for packaging, storing and/or transporting a good selected from the group consisting of food, beverage and chemical wherein the good is preferably a chemical, wherein the chemical is preferably a hazardous substance (transported as dangerous good) or an agrochemical, more preferably an agrochemical.

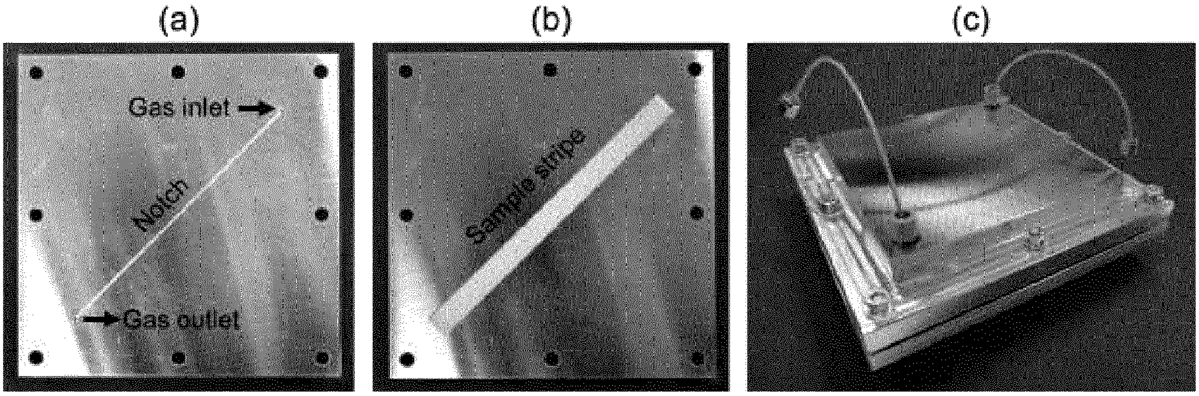
(a)
(b)
(c)
Gas inlet
Notch
Gas outlet
Sample stripe

Fig. 1

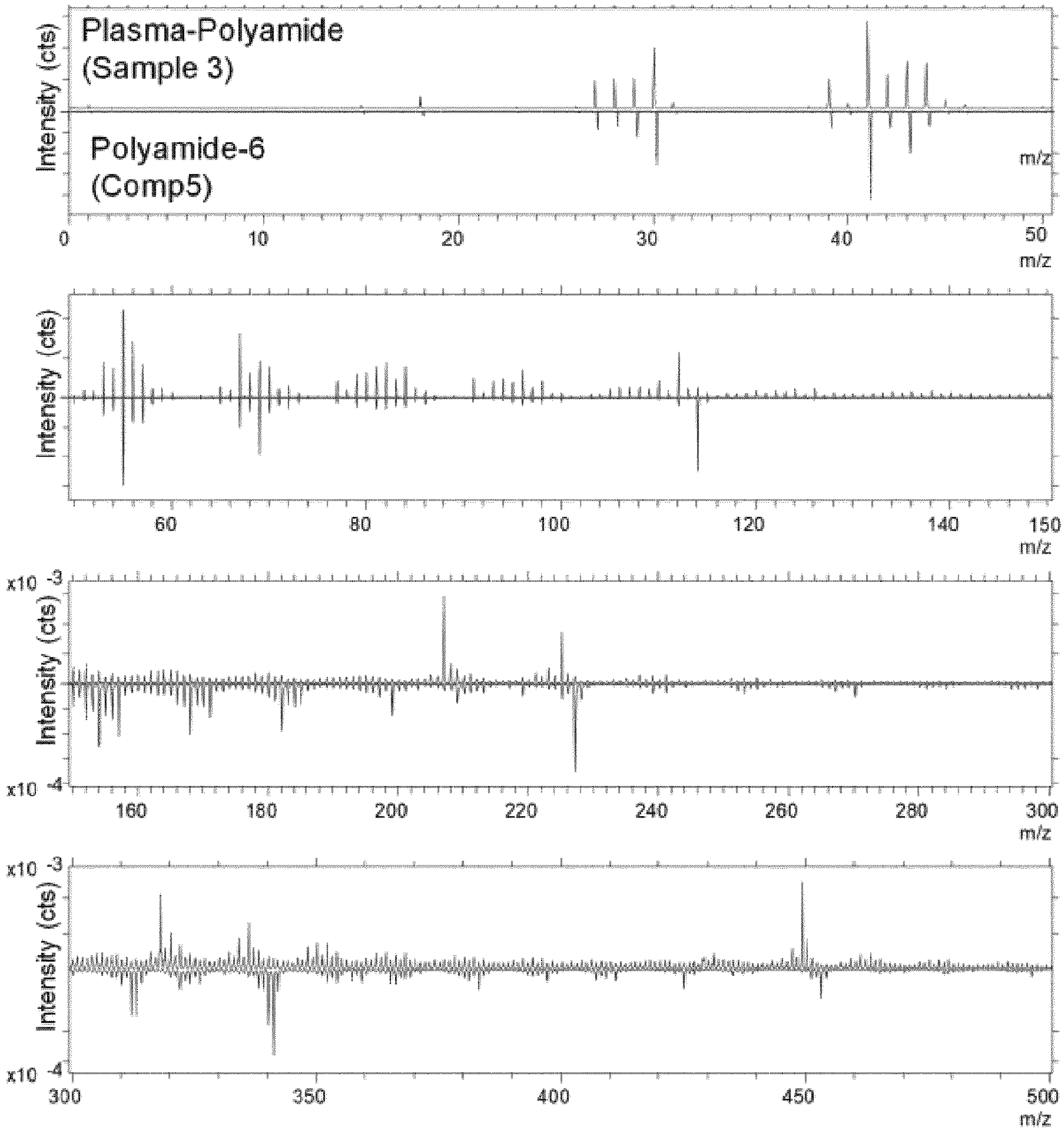
Plasma-Polyamide
(Sample 3)
Polyamide-6
(Comp5)
Intensity (cts)
m/z
x10 -3
x10 -4

Fig. 2

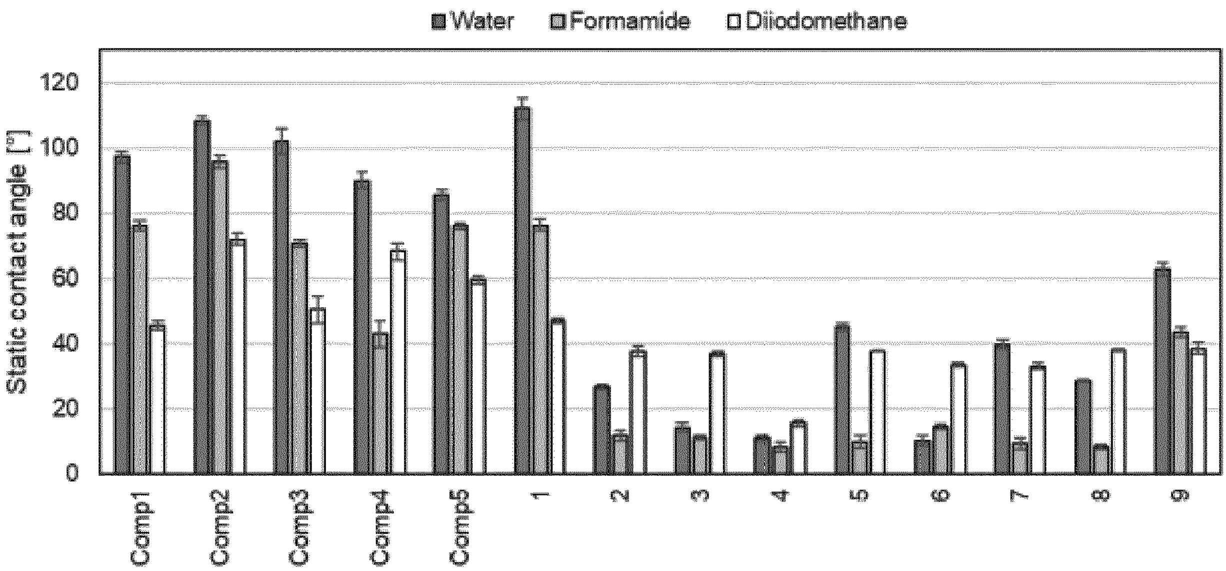
Water
Formamide
Diiodomethane
Static contact angle [°]
120
100
80
60
40
20
0
Comp1
Comp2
Comp3
Comp4
Comp5
1
2
3
4
5
6
7
8
9

Fig. 3

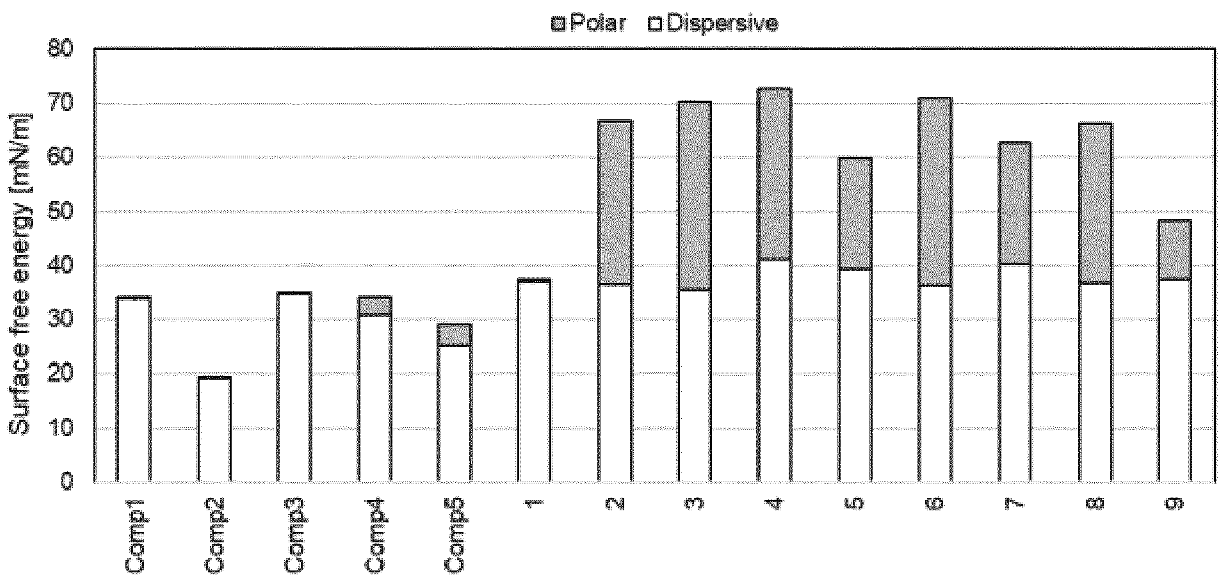
Polar
Dispersive
Surface free energy [mN/m]
80
70
60
50
40
30
20
10
0
Comp1
Comp2
Comp3
Comp4
Comp5
1
2
3
4
5
6
7
8
9

Fig. 4

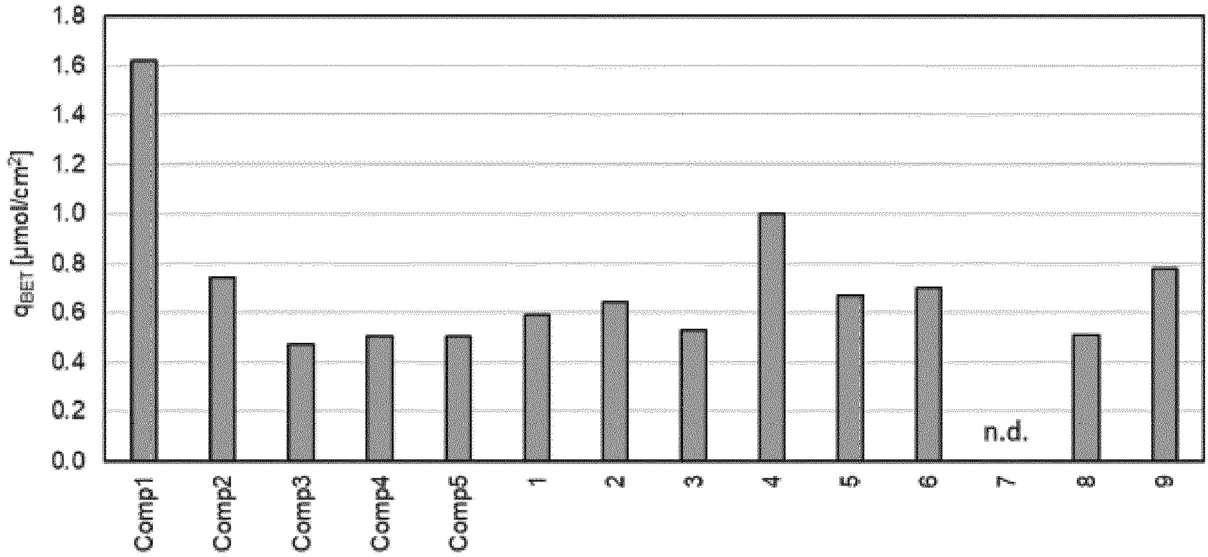
1.8
1.6
1.4
1.2
1.0
0.8
0.6
0.4
0.2
0.0
$q_{BET}$ [µmol/cm$^2$]
n.d.
Comp1
Comp2
Comp3
Comp4
Comp5
1
2
3
4
5
6
7
8
9

Fig. 5

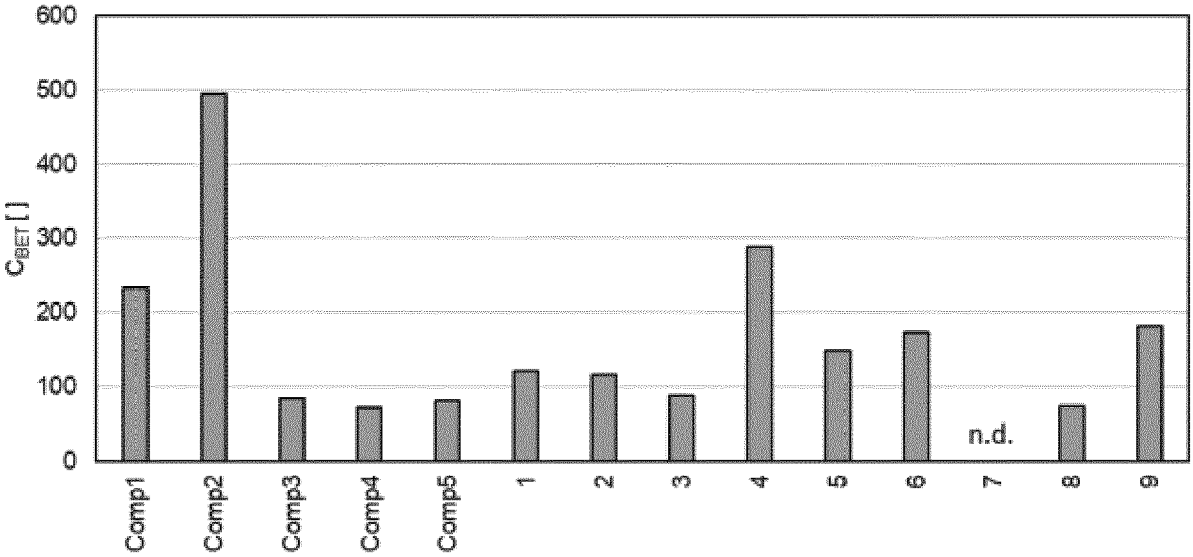
600
500
400
300
200
100
0
$C_{BET}$ [ ]
n.d.
Comp1
Comp2
Comp3
Comp4
Comp5
1
2
3
4
5
6
7
8
9

Fig. 6

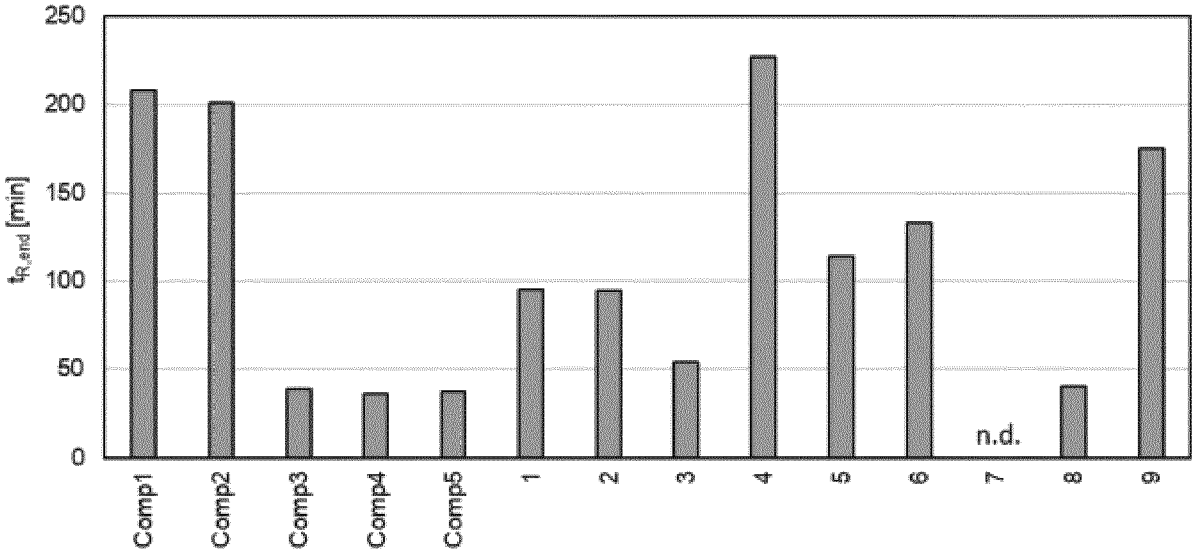
250
200
150
100
50
0
$t_{R,end}$ [min]
Comp1
Comp2
Comp3
Comp4
Comp5
1
2
3
4
5
6
7
8
9
n.d.

Fig. 7

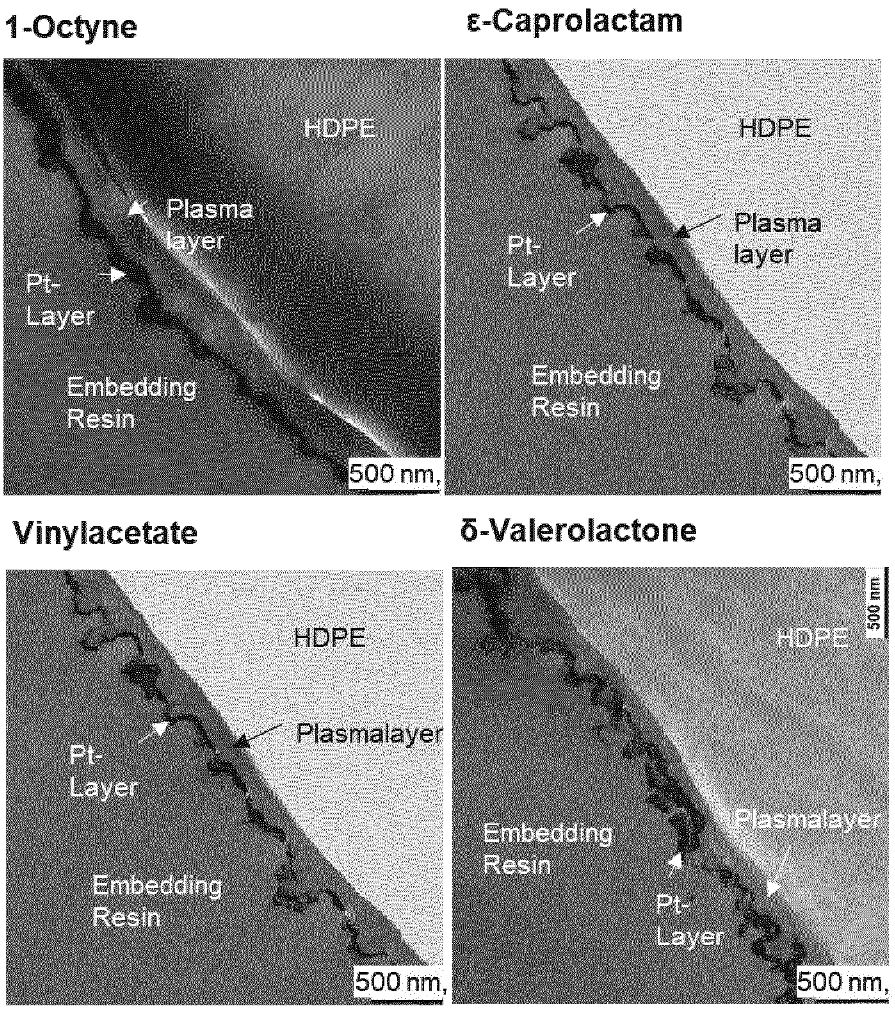
1-Octyne
HDPE
Plasma layer
Pt-Layer
Embedding Resin
500 nm
ε-Caprolactam
HDPE
Plasma layer
Pt-Layer
Embedding Resin
500 nm
Vinylacetate
HDPE
Plasmalayer
Pt-Layer
Embedding Resin
500 nm
δ-Valerolactone
HDPE
500 nm
Plasmalayer
Embedding Resin
Pt-Layer
500 nm

Fig. 8

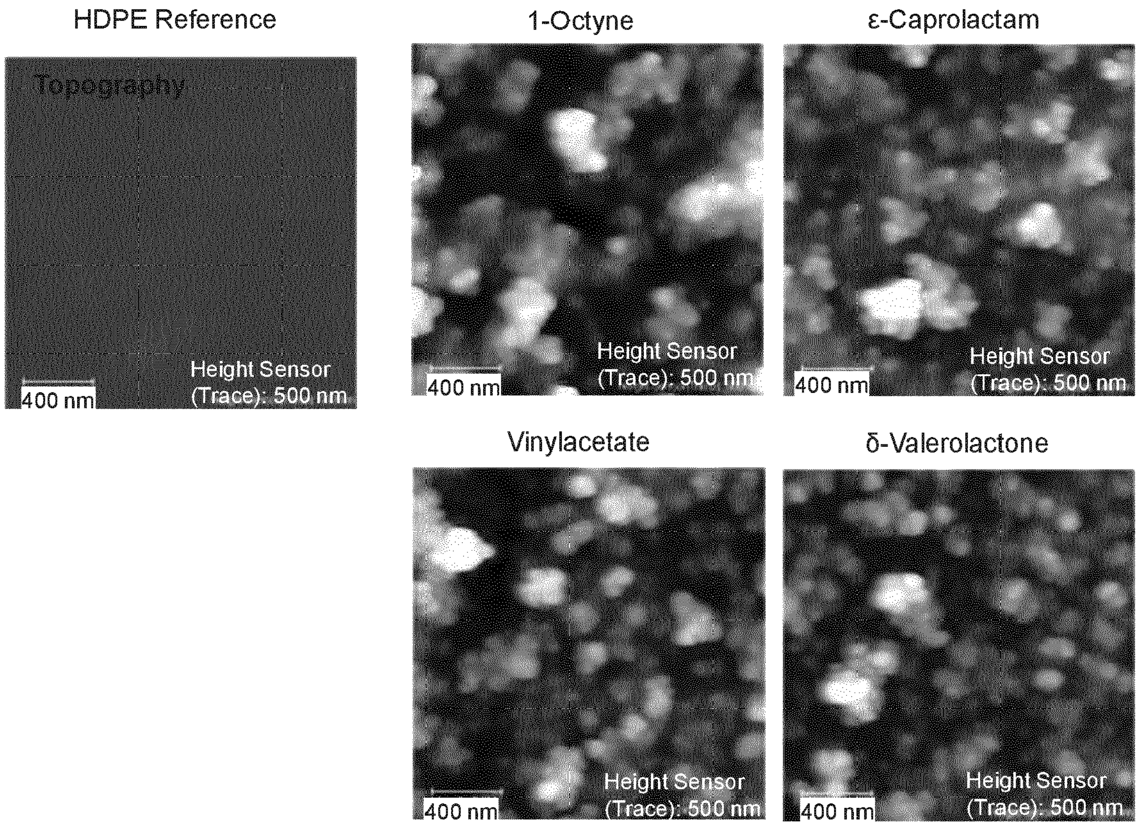
HDPE Reference
Topography
Height Sensor
(Trace): 500 nm
400 nm
1-Octyne
Height Sensor
(Trace): 500 nm
400 nm
ε-Caprolactam
Height Sensor
(Trace): 500 nm
400 nm
Vinylacetate
Height Sensor
(Trace): 500 nm
400 nm
δ-Valerolactone
Height Sensor
(Trace): 500 nm
400 nm

Fig. 9

Europäisches Patentamt
European Patent Office
Office européen des brevets

# EUROPEAN SEARCH REPORT

Application Number
EP 22 17 8306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 6 037 016 A (DEVLIN DAVID JAMES [US] ET AL) 14 March 2000 (2000-03-14)<br>* column 3, line 62 *<br>----- | 1,6 | INV.<br>B05D1/00<br>C23C16/50<br>C23C16/455 |
| A | US 2020/208257 A1 (HAGEN JAN [DE] ET AL) 2 July 2020 (2020-07-02)<br>* paragraph [0030] *<br>----- | 1,4,6-15 | |
| X<br>Y | US 2005/287771 A1 (SEAMONS MARTIN J [US] ET AL) 29 December 2005 (2005-12-29)<br>* paragraph [0014] *<br>* paragraph [0029]; figure 6 *<br>* paragraph [0073]; figures 1a-1e *<br>* paragraph [0031] *<br>* figure 6 *<br>----- | 1,4,7,9, 11,12<br>1,6,12, 13,15 | |
| X | US 2004/202880 A1 (WINTHER-JENSEN BJORN [DK] ET AL) 14 October 2004 (2004-10-14)<br>* paragraph [0056] *<br>* paragraph [0058] *<br>* paragraph [0046] *<br>* paragraph [0081] *<br>* paragraph [0073] *<br>----- | 1,4, 7-10,14 | TECHNICAL FIELDS SEARCHED (IPC)<br>B05D<br>C23D<br>C23C |
| Y | JANG HYO JUN ET AL: "A Review of Plasma Synthesis Methods for Polymer Films and Nanoparticles under Atmospheric Pressure Conditions",<br>POLYMERS,<br>vol. 13, no. 14, 10 July 2021 (2021-07-10), page 2267, XP093001415,<br>CH<br>ISSN: 2073-4360, DOI: 10.3390/polym13142267<br>* paragraph [02.1]; figure 2 *<br>----- | 12 | |

-/--

The present search report has been drawn up for all claims

2

| Place of search | Date of completion of the search | Examiner |
|---|---|---|
| The Hague | 2 February 2023 | Kudelka, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 3

Europäisches Patentamt
European Patent Office
Office européen des brevets

# EUROPEAN SEARCH REPORT

Application Number
EP 22 17 8306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | GB 2 494 946 A (EUROPLASMA NV [BE]) 27 March 2013 (2013-03-27)<br>* example 2; table 2 *<br>----- | 13 | |
| Y | JP 2001 261075 A (TOPPAN PRINTING CO LTD) 26 September 2001 (2001-09-26)<br>* paragraphs [0004], [0018] *<br>----- | 15 | |
| X | US 7 067 405 B2 (SIGMA LAB ARIZONA INC [US]) 27 June 2006 (2006-06-27)<br>* column 7, line 1 - line 25; figure 7 *<br>* column 7, line 27 - line 30 *<br>* column 15, line 50 *<br>* column 15, line 59 *<br>* column 7, line 16 *<br>* example 1 *<br>----- | 1,2,5,7, 9,10,14 | |
| X | JP 2004 054048 A (HOYA CORP) 19 February 2004 (2004-02-19)<br>* paragraph [0005] *<br>* paragraph [0013] *<br>* paragraph [0010] *<br>----- | 1,2,7,9, 10 | TECHNICAL FIELDS SEARCHED (IPC) |
| X | PETISCO-FERRERO S ET AL: "Surface functionalization of an osteoconductive filler by plasma polymerization of poly([epsilon]-caprolactone) and poly(acrylic acid) films", APPLIED SURFACE SCIENCE, ELSEVIER, AMSTERDAM , NL, vol. 386, 9 June 2016 (2016-06-09), pages 327-336, XP029670588, ISSN: 0169-4332, DOI: 10.1016/J.APSUSC.2016.06.040<br>* paragraph [02.2] *<br>-----<br>-/-- | 1,3,7,9, 10 | |

The present search report has been drawn up for all claims

2

| Place of search | Date of completion of the search | Examiner |
|---|---|---|
| The Hague | 2 February 2023 | Kudelka, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................
& : member of the same patent family, corresponding document

EPO FORM 1503 03.82 (P04C01)

page 2 of 3

Europäisches Patentamt
European Patent Office
Office européen des brevets

# EUROPEAN SEARCH REPORT

Application Number
EP 22 17 8306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 169 127 B1 (LOHMANN DIETER [CH] ET AL) 2 January 2001 (2001-01-02)<br>* column 19 *<br>* example B1 *<br>----- | 1,2,5,7,9,10 | |
| X | NORRMAN KION ET AL: "Controlling the Plasma-Polymerization Process ofN-Vinyl-2-pyrrolidone",<br>PLASMA PROCESSES AND POLYMERS,<br>vol. 2, no. 5, 14 June 2005 (2005-06-14), pages 414-423, XP93020170,<br>DE<br>ISSN: 1612-8850, DOI: 10.1002/ppap.200400067<br>* page 415; figure 1 *<br>* table 1 *<br>----- | 1,2,5,7,9,10 | |
| X | MARINKOVA D ET AL: "Plasmon microscopy and imaging ellipsometry of Artrobacter oxydans attached on polymer films",<br>COLLOIDS AND SURFACES B: BIOINTERFACES, ELSEVIER AMSTERDAM, NL,<br>vol. 65, no. 2,<br>1 September 2008 (2008-09-01), pages 276-280, XP022822656,<br>ISSN: 0927-7765, DOI: 10.1016/J.COLSURFB.2008.04.014<br>[retrieved on 2008-05-04]<br>* paragraph [2.2.4] *<br>----- | 1,3 | TECHNICAL FIELDS SEARCHED (IPC) |

The present search report has been drawn up for all claims

| Place of search | Date of completion of the search | Examiner |
|---|---|---|
| The Hague | 2 February 2023 | Kudelka, Stephan |

2

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

page 3 of 3

Europäisches Patentamt
European Patent Office
Office européen des brevets

Application Number

EP 22 17 8306

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches Patentamt
European Patent Office
Office européen des brevets

# LACK OF UNITY OF INVENTION SHEET B

Application Number
EP 22 17 8306

The Search Division considers that the present European patent application does not comply with the requirements of unity of invention and relates to several inventions or groups of inventions, namely:

**1. claims: 4, 6(completely); 1, 7-15(partially)**

Coated substrate and method from a reaction product of vinylacetate and C5 to C8 alkyne.

---

**2. claims: 2(completely); 1, 7-15(partially)**

Coated substrate and method from a reaction product of lactam with 4 to 8 ring atoms.

---

**3. claims: 3(completely); 1, 7-15(partially)**

Coated substrate and method from a reaction product of lactone with 4 to 8 ring atoms.

---

**4. claims: 5(completely); 1, 7-15(partially)**

Coated substrate and method from a reaction product of polyvinylpyrrolidone.

---

# ANNEX TO THE EUROPEAN SEARCH REPORT ON EUROPEAN PATENT APPLICATION NO.

EP 22 17 8306

This annex lists the patent family members relating to the patent documents cited in the above-mentioned European search report. The members are as contained in the European Patent Office EDP file on
The European Patent Office is in no way liable for these particulars which are merely given for the purpose of information.

02-02-2023

| Patent document cited in search report | Publication date | Patent family member(s) | Publication date |
|---|---|---|---|
| US 6037016 A | 14-03-2000 | AU 712118 B2 | 28-10-1999 |
| | | BR 9611841 A | 09-03-1999 |
| | | CA 2239014 A1 | 12-06-1997 |
| | | CN 1203640 A | 30-12-1998 |
| | | DE 69624139 T2 | 12-06-2003 |
| | | EP 0876528 A1 | 11-11-1998 |
| | | JP 2000501781 A | 15-02-2000 |
| | | KR 19990071814 A | 27-09-1999 |
| | | UA 47445 C2 | 15-07-2002 |
| | | US 6037016 A | 14-03-2000 |
| | | WO 9720981 A1 | 12-06-1997 |
| US 2020208257 A1 | 02-07-2020 | CN 110914468 A | 24-03-2020 |
| | | EP 3658697 A1 | 03-06-2020 |
| | | KR 20200034773 A | 31-03-2020 |
| | | RU 2751017 C1 | 07-07-2021 |
| | | US 2020208257 A1 | 02-07-2020 |
| | | WO 2019020481 A1 | 31-01-2019 |
| US 2005287771 A1 | 29-12-2005 | JP 4879159 B2 | 22-02-2012 |
| | | JP 2007531987 A | 08-11-2007 |
| | | KR 20070004009 A | 05-01-2007 |
| | | TW I332034 B | 21-10-2010 |
| | | US 2005287771 A1 | 29-12-2005 |
| | | WO 2005087974 A2 | 22-09-2005 |
| US 2004202880 A1 | 14-10-2004 | EP 1390421 A1 | 25-02-2004 |
| | | US 2004202880 A1 | 14-10-2004 |
| | | WO 02094906 A1 | 28-11-2002 |
| GB 2494946 A | 27-03-2013 | NONE | |
| JP 2001261075 A | 26-09-2001 | NONE | |
| US 7067405 B2 | 27-06-2006 | US 2005020038 A1 | 27-01-2005 |
| | | WO 2006007336 A2 | 19-01-2006 |
| JP 2004054048 A | 19-02-2004 | JP 3893329 B2 | 14-03-2007 |
| | | JP 2004054048 A | 19-02-2004 |
| US 6169127 B1 | 02-01-2001 | AR 004877 A1 | 10-03-1999 |
| | | EP 0834352 A1 | 08-04-1998 |
| | | US 6169127 B1 | 02-01-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007072120 A1
- WO 2006081637 A1, Vangeneugden
- US 20220112595 A1


### Non-patent literature cited in the description


- **D. OWENS ; R. WENDT.** *J. Appl. Polym. Sci.,* 1969, vol. 13, 1741
- urface Properties Characterization by Inverse Gas Chromatography (IGC) Applications. **ERIC BRENDLÉ ; EUGENE PAPIRER.** Powders and Fibers. ImprintCRC Press, 2006, 76
- Surface Properties Characterization by Inverse Gas Chromatography (IGC) Applications. **ERIC BRENDLÉ ; EUGENE PAPIRER.** Powders and Fibers. ImprintCRC Press, 2006, 76
- **RUNAUER, STEPHEN ; EMMETT, P. H. ; TELLER, EDWARD.** Adsorption of Gases in Multimolecular Layers. *Journal of the American Chemical Society,* 1938, vol. 60 (2), 309-319
- **BRUNAUER, STEPHEN ; EMMETT, P. H. ; TELLER, EDWARD.** Adsorption of Gases in Multimolecular Layers. *Journal of the American Chemical Society,* 1938, vol. 60 (2), 309-319
- **VANGENEUGDEN et al.** *the 21st International Symposium on Plasma Chemistry, https://www.ispc-conference.org/ispcproc/ispc21/ID287.pdf*